(19) Europäisches Patentamt
European Patent Office
Office européen des brevets

(11) **EP 2 421 145 B1**

(12) **EUROPÄISCHE PATENTSCHRIFT**

(45) Veröffentlichungstag und Bekanntmachung des Hinweises auf die Patenterteilung:
**11.02.2015 Patentblatt 2015/07**

(21) Anmeldenummer: **10172899.6**

(22) Anmeldetag: **16.08.2010**

(51) Int Cl.:
*H02P 21/14* (2006.01)  *H02P 23/14* (2006.01)
*G01R 31/34* (2006.01)

(54) **Vorrichtung und Verfahren zur drehgeberlosen Identifikation elektrischer Ersatzschaltbildparameter eines Drehstrom-Asynchronmotors**

Apparatus and method for identifying equivalent circuit parameters of an alternating current asynchronous motor without using a rotary encoder

Dispositif et procédé d'identification des paramètres d'un schéma électrique équivalent d'un moteur asynchrone triphasé sans utilisation d'encodeur de vitesse

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**22.02.2012 Patentblatt 2012/08**

(73) Patentinhaber: **Baumüller Nürnberg GmbH 90482 Nürnberg (DE)**

(72) Erfinder:
- **Villwock, Sebastian 95701 Pechbrunn (DE)**
- **Zatocil, Heiko 90429 Nürnberg (DE)**

(74) Vertreter: **Götz, Georg Alois Intellectual Property IP-GÖTZ Patent- und Rechtsanwälte Postfach 35 45 90017 Nürnberg (DE)**

(56) Entgegenhaltungen:
**EP-A2- 0 704 709     DE-A1- 4 411 149 JP-A- 2001 103 798**

- **VILLWOCK S ET AL: "Application of the welch-method for the automatic parameter identification of electrical drives", INDUSTRIAL ELECTRONICS SOCIETY, 2005. IECON 2005. 31ST ANNUAL CONFERENCE OF IEEE, IEEE, PISCATAWAY, NJ, USA LNKD- DOI: 10.1109/IECON.2005.1569118, 6. November 2005 (2005-11-06), Seiten 1449-1454, XP010876187, ISBN: 978-0-7803-9252-6**

EP 2 421 145 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung geht aus von einem Verfahren, einer Einrichtung, einer Vorrichtung und einer Verfahrensverwendung für eine drehgeberlose Identifikation elektrischer Ersatzschaltbildparameter eines Drehstrom-Asynchronmotors. Elektrische Ersatzschaltbildparameter ermöglichen die Charakterisierung eines Drehstrommotors mittels elektrischer Ersatzschaltbildkomponenten, so dass das elektrische Verhalten des Motors im Betrieb nachgebildet werden kann.

STAND DER TECHNIK

Aus dem Stand der Technik, z.B. der JP 2001 103798 A, der DE 44 11 149 A1 oder der EP 0 704 709 A2 sind verschiedene Methoden bekannt, um das elektrische Verhalten eines Drehstrommotors zu bestimmen. In der Regel werden Gleichstrom-, Leerlauf-, und Kurzschlussversuche an einem Motor vorgenommen, um das elektrische Verhalten in derartigen Betriebsszenarien zu messen und daraus das elektrische Betriebsverhalten für andere Betriebsfälle ableiten zu können. Typischerweise verwendet man zur Charakterisierung des elektrischen Verhaltens eines Asynchronmotors ein sogenanntes T-Ersatzschaltbild, bei dem die Stator- und Rotorspule bzw. das elektrische Stator- und Rotorverhalten mittels zweier ohmscher Widerstände $R_1$, $R'_2$, zweier Spuleninduktivitäten $L_{1\sigma}$, $L'_{2\sigma}$ sowie einer Hauptinduktivität $L_h$ nachgebildet wird. Mittels Gleichstrom-, Leerlauf- und Kurzschlussversuche wird versucht, die Größe der konzentrierten Bauteilparameter des T-Ersatzschaltbilds zu bestimmen, wobei insbesondere bezüglich der Streuinduktivitäten $L_{1\sigma}$, $L'_{2\sigma}$ in der Regel nur eine Schätzung vorgenommen werden kann. Die vorgenannten Versuche stellen Zeitbereichsverfahren dar, bei dem sich der Motor bewegt, und die einen Antrieb des Motors in einer Testumgebung erfordern. Beim Kurzschlussversuch muss der Motor festgestellt werden, wobei sich die Gefahr einer Überlastung ergeben kann. Im Leerlaufversuch wird die Maschine frei drehend betrieben, wobei es zur mechanischen Überlast kommen kann. Bei einem Gleichstromversuch kann der ohmsche Statorwiderstand $R_1$, und bei einem Kurzschlussversuch der ohmsche Rotorwiderstand $R'_2$, sowie die Streuinduktivitäten $L_{1\sigma}$, $L'_{2\sigma}$ bestimmt werden, wobei sich die Gefahr mechanischer oder elektrischer Überlastung ergeben kann. Auf Basis des Leerlaufversuchs kann die Hauptinduktivität $L_h$ abgeschätzt werden.

Die vorgenannten Kurzschluss-, Leerlauf- und Gleichstromversuche berücksichtigen daneben in vielen Fällen Messergebnisse mechanischer Sensoren, wie beispielsweise Positionssensoren, Winkel- oder Drehzahlsensoren, um eine Korrelation des Betriebsverhaltens des Motors bei verschiedenen Umdrehungszahlen herleiten zu können.

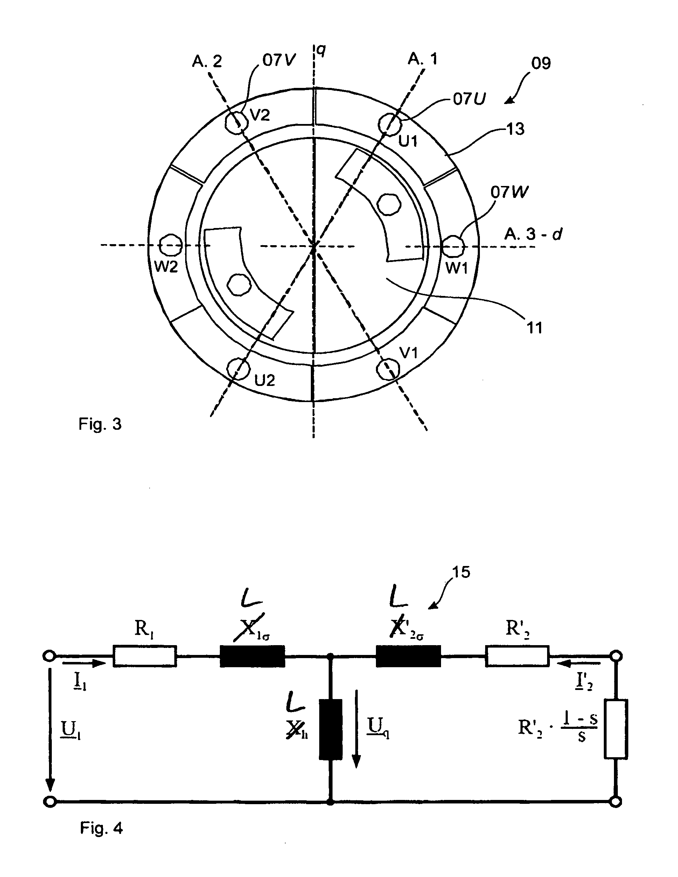

In der Fig. 4 ist das T-Ersatzschaltbild eines Asynchronmotors bezüglich einer einphasigen Betrachtung dargestellt, wobei unter Kenntnis der genannten Ersatzschaltbildgrößen das elektrische Betriebsverhalten des Drehstrommotors in einem stationären Betriebsfall, d.h. bei konstanter Drehzahl und Belastung abschätzbar wird. Der Parameter $s$ kennzeichnet den Schlupf, d. h. das Nacheilen des drehenden Rotors gegenüber dem rotierenden Statormagnetfeld. Hieraus lässt sich die Admittanz des Motors im Betriebsverhalten bestimmen, die sich nach folgender Gleichung ergibt:

$$G = \underline{Y} = \cfrac{1}{R_1 + s\,L_{1\sigma} + \cfrac{s\,L_h \cdot \left(R'_2 + s\,L'_{2\sigma}\right)}{R'_2 + s \cdot \left(\underbrace{L_h + L'_{2\sigma}}_{=L_2}\right)}}$$

$$G = \underline{Y} = \frac{s\,L_2 + R'_2}{s^2\left(L_{1\sigma}\,L_2 + L_h\,L'_{2\sigma}\right) + s\left(L_1\,R'_2 + L_2\,R_1\right) + R_1\,R'_2}$$

$$G = \underline{Y} = \frac{a_1\,s + a_0}{b_2\,s^2 + b_1\,s + b_0}$$

mit $a_0 = R_2'$, $a_1 = L_2$, $b_0 = R_1 R_2'$, $b_1 = \left(L_1 R_2' + L_2 R_1\right)$, $b_2 = \left(L_{1\sigma} L_2 + L_h L_{2\sigma}'\right)$. Die oben genannte Admittanz als Übertragungsfunktion $G = \underline{Y} = I_1/U_1$ wird unter der Annahme einer Schlupfgröße s von 1, d.h. Stillstand hergeleitet. In der Formel bezeichnet übrigens 's' nicht den Schlupf, sondern die komplexe Frequenz im Laplace-Bereich. Die Parameterbestimmung im Leerlauf- Kurzschluß- und Gleichstromversuch beruhen auf diesem T-Ersatzschaltbild. Bezüglich einer komplizierteren Betrachtung in einem später dargestellten $\alpha/\beta$ oder $d/q$-Koordinatensystem der Motorspannungen und -ströme können die gleichen Ersatzschaltbildparameter berücksichtigt werden, allerdings erlaubt diese Betrachtungsweise nicht nur eine stationäre Charakterisierung des Motors, sondern ermöglicht eine Beschreibung des dynamischen Verhaltens.

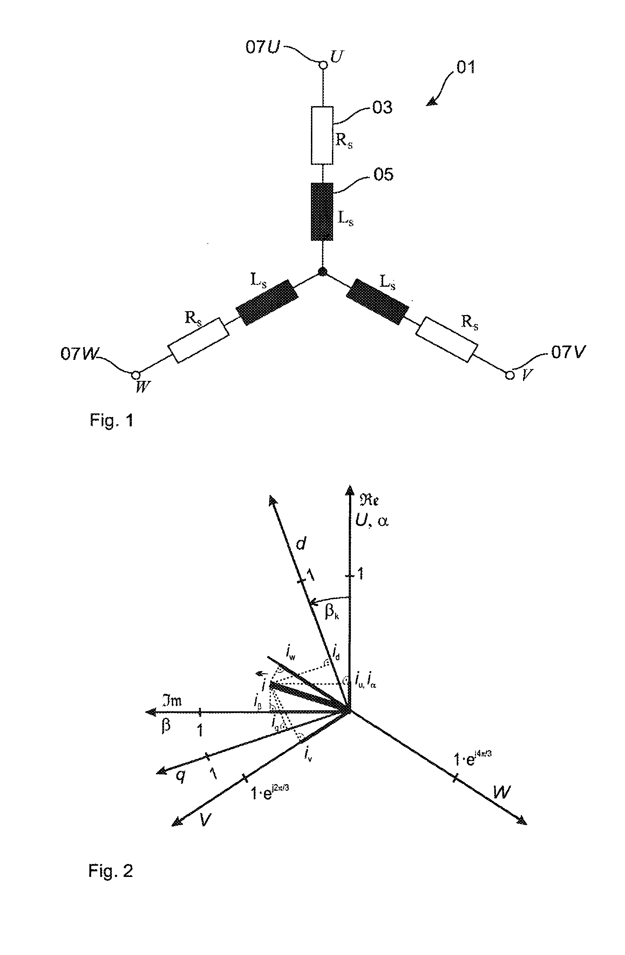

In einem Dreiphasensystem ergibt sich in Y- oder $\Delta$-Schaltung durch Einspeisung zweier Phasen jeweils der Strom der dritten Phase nach der Regel $I_u + I_v + I_w = 0$ bei fehlender Sternpunkterdung. Aus diesem Grund lässt sich ein Dreiphasensystem auch mittels zweier Koordinaten beschreiben, wobei zur Beschreibung des Gesamtstroms ein Koordinatensystem in der komplexen Ebene betrachtet werden kann, bei der die beiden Koordinaten Realteil und Imaginärteil als $\alpha$- und $\beta$-Koordinaten bezüglich der ortsfesten Ausrichtung der Statorwicklungen nach Fig. 1 bezeichnet werden können. Das $\alpha/\beta$-Koordinatensystem beschreibt beispielsweise die Richtung des Stromflusses oder die Rotorflußachse in dem ruhenden Bezugssystem des Stators des Drehstrommotors. Bezüglich der magnetischen Ausrichtung des Läufers kann ein zweites sich drehendes Koordinatensystem eingeführt werden, dessen Achsen als $d$- und $q$-Achse des Rotors bezeichnet werden, wie es in Fig. 2 dargestellt ist. Die $d$-Achse bezeichnet die Richtung des Läuferflusses und die $q$-Achse die hierzu rechtwinklige Querflussachse. Eine Ausrichtung eines Statormagnetfelds in Richtung der $d$-Achse des Rotors bewirkt quasi eine Feststellung des Rotors, während eine Stator-Magnetfeldausrichtung in Richtung der $q$-Achse des Rotors ein Drehmoment auf den Rotor bewirkt. Eine Transformation von $\alpha/\beta$-Statorkoordinatensystem in das sich drehende $d/q$-Rotorkoordinatensystem kann über den Drehwinkel $\beta_k$ zwischen der Wicklungsachse der Phase $U$ des Stators und der Längsachse des Rotormagnetfeldes hergestellt werden. Diesbezüglich können ein Gesamtmotorstrom $I$, bzw. dessen drei Phasenströme $I_u$, $I_v$ und $I_w$ im statorfesten $\alpha/\beta$-Koordinatensystem oder im sich mit dem Läufer drehenden $d/q$-Koordinatensystem betrachtet werden. Bezüglich der Umrechnung der Strangströme des Drehstrom-Asynchronmotors in das $\alpha/\beta$-Koordinatensystem gilt folgender Zusammenhang:

$$\begin{pmatrix} i_\alpha \\ i_\beta \end{pmatrix} = \begin{pmatrix} 1 & 0 & 0 \\ 0 & \dfrac{\sqrt{3}}{3} & -\dfrac{\sqrt{3}}{3} \end{pmatrix} \begin{pmatrix} i_u \\ i_v \\ i_w \end{pmatrix}, \qquad \begin{pmatrix} i_u \\ i_v \\ i_w \end{pmatrix} = \begin{pmatrix} 1 & 0 \\ -\dfrac{1}{2} & \dfrac{\sqrt{3}}{2} \\ -\dfrac{1}{2} & -\dfrac{\sqrt{3}}{2} \end{pmatrix} \begin{pmatrix} i_\alpha \\ i_\beta \end{pmatrix},$$

der mittels Berücksichtigung des Rotorflußwinkels $\beta_k$ für das $d/q$-Koordinatensystem modifizierbar ist. Zur nachfolgenden mathematischen Erfassung der Zusammenhänge wird eine Betrachtung im $\alpha/\beta$-Statorkoordinatensystem nach Fig. 2 durchgeführt, wobei das in Fig. 4 dargestellte T-Ersatzschaltbild, eine Ersatzschaltbildcharakterisierung der Drehstrom-Asynchronmaschine in einem einphasigen System mit Speisespannungen- und Ströme $U_1$, $I_1$ sowie $U_2$, $I_2$ beschreibt.

Ausgehend von den Phasenspannungen $U_U$, $U_V$ und $U_W$ und Strangströmen $I_U$, $I_V$ und $I_W$ werden diese gemäß der obigen Transformation in das $\alpha/\beta$-Koordinatensystem überführt. Somit lässt sich das elektrische Verhalten der Drehstrom-Asynchronmaschine mit Hilfe der Eingangsgrößen $U_1$ oder $U_2$ und Ausgangsgrößen $I_1$ oder $I_2$ betrachten. Diesbezüglich lassen sich getrennte Betrachtungsweisen bezüglich der $\alpha$- und $\beta$-Koordinate durchführen, so dass sich vier Übertragungsfunktionen, beziehungsweise Admittanzen ergeben können:

$$G_1 = I_{1\alpha}/U_{1\alpha},$$

$$G_2 = I_{1\beta}/U_{1\alpha},$$

$$G_3 = I_{1\alpha}/U_{1\beta},$$

$$G_4 = I_{1\beta}/U_{1\beta}.$$

Im Fall einer identischen Einspeisung in $\alpha$- und $\beta$- Achsenrichtung und Bestimmung und Vergleich der Übertragungsfunktionen $G_1$, $G_2$, $G_3$ oder $G_4$, die beim grundsätzlich identischen und symmetrischem Ersatzschaltbild die gleichen Übertragungscharakteristika aufweisen, kann eine Verifikation eines Analyseergebnisses erreicht werden. Hierzu kann es vorteilhaft denkbar sein, die Höhe der Testsignalspannung $U_{1\beta}$ zu variieren und jeweils Parameteridentifikationen mit geänderten Spannungswerten durchzuführen, wobei die sich ergebenden Parameter als Durchschnitt oder gewichteter Parameter aus den Ergebnissen der einzelnen Parameteridentifikationen ermittelbar sein können. Somit können Fehler in der Bestimmung vermindert werden, so dass ein genaueres Ergebnis erzielt werden kann.

Aus dem Stand der Technik ist zur Bestimmung mechanischer Kenngrößen eines Drehstrommotors, insbesondere zur Fehlerdiagnose mechanischer Teile oder zur mechanischen Systemidentifikation beim Betrieb in einem mechanischen Verband bekannt, ein Pseudo-Rausch-Binär-Signals (PRBS) als elektrische Testanregung einzusetzen. Dabei stellt das mechanische System ein SISO-System (Single-Input Single-Output) dar, bei der mit Hilfe einer einzigen mechanischen oder elektrischen Eingangsgröße eine einzige mechanische Ausgangsgröße gemessen werden kann. Die Eingangsgröße wird mit Hilfe des Pseudo-Rausch-Binär-Signals angeregt, so dass in der Ausgangsgröße ein breitbandiges Verhalten des SISO-Systems bestimmt werden kann. Mit Hilfe signaltheoretischer Methoden der Frequenztransformation und Parameteridentifikation anhand des Frequenzverhaltens können Kenngrößen des mechanischen Systems bei Kenntnis der zugrundeliegenden Systemgleichung abgeleitet werden.

Im Falle elektrischer Kenngrößen handelt es sich allerdings um ein sogenanntes MIMO-System (Multiple-Input Multiple-Output), bei dem mehrere Eingangsgrößen (Strangspannungen) eingespeist und mehrere Ausgangsgrößen (Strangströme) extrahiert werden müssen. Aus diesem Grund können die aus dem Verfahren zur Identifikation mechanischer Größen bekannten Methoden nicht für die elektrische Systemcharakterisierung eines Drehstrommotors angewendet werden. Die Identifikation des mechanischen Systems ist umfassen in der Diesertation von Sebastian Villwock "Identifikationsmethoden für die automatisierte Inbetriebnahme und Zustandsübomachung elektrischer Antriebe", Universität Siegen, 2007, (Druckschrift [1]) beschrieben. Des Weiteren ist eine diesbezüglich verwendete signaltheoretische Methode für die Parameteridentifikation eines mechanischen Systems indem Zeitschriftenbeitrag: S. Villwock, J. M. Pacas: " Applikation of the Welch-Method for the Identification of Two and Three Mass Systems", IEEE Transactions on Industrial Electronics, Vol. 55, No. 1, Januar 2008, S, 457-466 (Druckschrift [2]) beschrieben. Ein gattungsähnliches Verfahren ist im Rahmen eines Konferenzartikels in: P. Szczupak, J. M. Pacas: "Automatic identification of a PMSM Drive Equipped with an Output LC-Filter", IEEE Industrial Electronics, IECON 2006, 32nd Annual Confrence on November 2006, S. 1143-1148 (Druckschrift [3]) vorgestellt.

Aufgabe der vorliegenden Erfindung ist es, ausgehend von einem elektrischen T-Ersatzschaltbild einer Drehstrom-Asynchronmaschine ein Verfahren zur Bestimmung der Ersatzschalbildkenngrößen vorzuschlagen, wobei eine Parameteridentifikation ohne elektrische oder mechanische Belastung des Motors ermöglicht wird, der Rotor stillsteht und durch eine einzige Messung alle elektrischen Ersatzschaltbildparameter für eine Beschreibung des elektrischen Verhaltens des Drehstrommotors für einen großen Frequenzbereich ermittelt werden kann. Vorteilhafte Fortbildungen der Erfindung sind Gegenstand der Unteransprüche.

OFFENBARUNG DER ERFINDUNG

In einem ersten Aspekt der Erfindung wird ein Verfahren nach Anspruch 1 vorgeschlagen.

Eine Stillstandslage des Rotors bedeutet, dass sich der Winkel des Rotors gegenüber dem Stator nicht ändert, und somit der Drehwinkel zwischen $\alpha$- und d-Achse konstant und gegebenenfalls bekannt ist. Nach Einnahme einer Stillstandslage des Rotors wird gleichsinnig in beide Achsenrichtungen, d.h. in $\alpha$-Achsenrichtung und $\beta$-Achsenrichtung des Stators ein Testsignal eingespeist. Die Struktur des Testsignals bestimmt, welche Frequenzkomponenten oder -bereiche messbar sind und mit welcher Genauigkeit die Ersatzschaltbildparameter identifiziert werden können, wobei Parameter entsprechend der Frequenzabdeckung des Testsignals extrahiert werden können. Eine Einspeisung der Testsignalspannungen $U_{1\alpha}$ und $U_{1\beta}$ erzeugt Meßsignalströme $I_{1\alpha}$, $I_{1\beta}$, die gemessen werden. Die Einspeisung der beiden Strangspannungen zur Messung der beiden Strangströme kann beispielsweise mittels eines 2/3-Phasen-Konverters erfolgen, der obiger Matrixrelation folgend aus den beiden Spannungen $U_{1\alpha}$ und $U_{1\beta}$ die drei Phasenspannungen $U_U$, $U_V$ und $U_W$ erzeugen bzw. aus den drei gemessenen Strömen $I_U$, $I_V$ und $I_W$ die beiden Ströme $I_{1\alpha}$ und $I_{1\beta}$ transformieren kann. Eine Einspeisung des Testsignals kann beispielsweise durch eine Steuerung eines Wechselrichters der Motorsteuerungsvorrichtung des Drehstrommotors erfolgen. Alternativ können die Testsignalspannungen direkt in die Stränge der Asynchronmaschine eingespeist werden. Die Messung der Strangströme kann über die selben Strommessinstrumente erfolgen, die bei einer drehgeberlosen Regelung im Betrieb des Drehstrommotors verwendet werden. Im Zeitbereich können die eingespeisten Testsignalspannungen und die gemessenen Meßsignalströme als digital erfasste zeitliche Abtastwerte aufgezeichnet werden, und auf deren Basis können die Ersatzschaltbildparameter extrahiert werden. Dies erfolgt bevorzugt durch eine Frequenzbereichsanalyse, d.h. einer Frequenztransformation der aufgezeichneten Zeitbereichsdaten, und einer Analyse des Frequenzgangs der gemessenen Übertragungsfunktionen $G_1$, $G_2$, $G_3$ oder $G_4$. Unter Kenntnis der vorgenannten Admittanzfunktion, die als Übertragungsfunktion im Frequenzbereich dargestellt werden kann, können die Koeffizienten der Übertragungsfunktion mittels einer geeigneten signaltheoretischen Methode ermittelt werden, wobei diese Koeffizienten zur Identifikation der Ersatzschaltbildkenngrößen $R_1$, $R'_2$, $L_{1\sigma}$, $L'_{2\sigma}$ und $L_h$ herangezogen werden können.

Während der gleichsinnigen Einspeisung des Testsignals in $\alpha$- und $\beta$-Koordinatenrichtung wird kein Drehmoment in der Maschine erzeugt, so dass der Rotor drehmomentfrei und in seiner Lage verbleibt. Hierdurch kann eine Messung im Stillstand des Motors vorgenommen werden, wobei keine Sensordaten berücksichtigt werden müssen und selbst die Parameter eines Motors im eingebauten Zustand innerhalb eines mechanischen Antriebsstrangs nachträglich extrahiert werden können, ohne dass die Art des Antriebsstrangs Einfluss auf die Messergebnisse hat. Dadurch, dass beide $\alpha/\beta$-Eingänge des Modells dasselbe Testsignal erhalten, ergibt sich das resultierende innere Drehmoment der Maschine zu 0, denn es gilt:

$$M_{mi} = \frac{3}{2}\, p\; \Im\left\{\bar{\Psi}_1^{s*}\; \bar{I}_1^{s}\right\}$$

$$M_{mi} = \frac{3}{2}\, p\; \Im\left\{\left(\Psi_{1\alpha} + j\Psi_{1\beta}\right)^{*} \cdot \left(I_{1\alpha} + jI_{1\beta}\right)\right\}$$

$$M_{mi} = \frac{3}{2}\, p\, \left(\Psi_{1\alpha}\, I_{1\beta} - \Psi_{1\beta}\, I_{1\alpha}\right)$$

Eine Bestimmung des Frequenzgangs der Übertragungsfunktion $G$ unter Kenntnis der zugrunde liegenden Admittanz-Formel $\underline{Y}$ ermöglicht die Extraktion der Ersatzschaltbildparameter. Somit kann durch eine Einspeisung eines insbesondere breitbandigen Testsignals mittels einer einzigen Messung Aussagen über die Ersatzschaltbildkenngrößen des Drehstrommotors getroffen werden. Hierzu werden signaltheoretische Methoden herangezogen, die die gemessenen Zeitbereichsdaten in Frequenzbereichsdaten transformieren, wobei der Frequenzgang formelmäßig erfasst werden kann, und mittels einer Parameterextraktion aus dem Frequenzgang die Koeffizienten der zugrundeliegenden Übertragungsfunktion und damit die Ersatzschaltbildgrößen identifiziert werden können.

Grundsätzlich kann statt einer Testspannungsvorgabe und Meßstrombestimmung auch eine Teststromvorgabe mit Meßspannungserfassung erfolgen. Allerdings weisen insbesondere leistungsstarke Motoren ein hochinduktives Verhalten auf, so daß zur Einprägung rechteckförmiger Stromschaltimpulse hohe Treiberspannungen angelegt werden müßten, wodurch eine Teststromeinprägung nur mit hohem Aufwand möglich ist.

Gemäß einer vorteilhaften Weiterbildung der Erfindung werden zumindest eine, insbesondere alle, Frequenzgangfunktionen $G_1 = I_{1\alpha}/U_{1\alpha}$, $G_2 = I_{1\beta}/U_{1\alpha}$, $G_3 = I_{1\alpha}/U_{1\beta}$, $G_4 = I_{1\beta}/U_{1\beta}$ zur Identifikation der Ersatzschaltbildparameter ermittelt, wobei eine Abweichung der Frequenzgangfunktionen von $G_1$, $G_2$, $G_3$ und/oder $G_4$ eine Wiederholung des Verfahrens oder eine Fehlersignalisierung bewirken kann. Grundsätzlich weisen die vier Admittanz-Funktionen ein identisches Frequenzverhalten auf und ergeben dieselben Parameter, da das zugrunde liegende Ersatzschaltbild symmetrische Bauteile umfasst und identische Widerstände und Induktivitätswerte beinhaltet. So können unter Vorliegen aller vier Kenngrößen vier Übertragungsfunktionen (Admittanzen) extrahiert werden, wobei im Falle eines Abweichens der vier Admittanzen auf eine Ungenauigkeit des Verfahrensablaufs geschlossen werden kann. Beispielsweise kann sich der Rotor noch nicht im Stillstand befinden, oder es können Fehler bei der Fouriertransformation aufgetreten sein, beispielsweise wurden zu wenige oder zu lange Signalfolgen eingespeist oder das Testsignal weist kein gleichmäßiges Frequenzspektrum auf. In diesem Fall ergibt sich eine Differenz zwischen den Frequenzverläufen, wonach eine Wiederholung des Verfahrens vorgenommen werden kann, oder eine Fehlersignalisierung ausgegeben werden kann, die auch auf einen Defekt des Asynchronmotors hinweisen kann.

Gemäß einer vorteilhaften Weiterbildung kann das Testsignal ein "Pseudo-Rausch-Binär-Signal sein. Das Testsignal sollte eine hohe Bandbreite aufweisen, um eine möglichst hohe Frequenzauflösung und eine breitbandige Analyse des elektrischen Motorverhaltens zu ermöglichen. Weißes Rauschen besitzt ein gleichverteiltes breitbandiges Frequenzspektrum. Ein Pseudo-Rausch-Binär-Signal (PRBS) ist ein binäres Signal, welches das Spektrum von weißem Rauschen approximiert. Es kann typischerweise die Werte +1 und -1 annehmen und wird alternativ zum weißen Rauschen verwendet. Vorteilhaft ist insbesondere die Reproduzierbarkeit des Signals, wobei häufig in der Regelungstechnik ein PRB-Signal zur Analyse eine Impulsantwort mittels einer Maximum-Length-Sequenco verwendet wird. Ein PRB-Testsignal lässt sich leicht durch linear rückgekoppelte Schieberegister erzeugen und kann beispielsweise durch einen DSP (Digital Signal Processor), FPGA (Field Programmable Gate Array) oder Mikrocontroller eines Motorreglers zur Ansteuerung des Wechselrichters erzeugt werden. Somit kann jede Motoransteuerelektronik solch ein PRB-Signal ohne größere Modifikation erzeugen und als Motorspannung in den Motor einspeisen.

Grundsätzlich kann eine Frequenzbereichstransformation von abgetasteten Zeitbereichsdaten zur Identifikation der Ersatzschaltbildparameter im Frequenzbereich beliebig erfolgen. Gemäß einer vorteilhaften Weiterbildung der Erfindung kann die Identifikation der Ersatzschaltbildparameter eine Fouriertransformation nach einem Periodogramm-Verfahren, bevorzugt ein Bartlett-Verfahren, insbesondere einem Welch-Verfahren umfassen. Im Rahmen eines Periodogramm-Verfahrens wird eine spektrale Leistungsdichte durch eine Fourier-Transformation einzelner Datenblöcke erreicht. Die Qualität der Spektralschätzung kann verbessert werden, indem eine Anzahl voneinander unabhängiger Periodogramme gemittelt wird. Dieses Verfahren ist in der Literatur unter dem Namen Bartlett-Methode bekannt, bei dem das gemessene Signal in Abschnitte aufgeteilt wird. Die Welch-Methode stellt eine Erweiterung der von Bartlett vorgeschlagenen Vorgehensweise dar. Zur Reduzierung des Leck-Effekts (engl. *Leakage-effect*) kommen hier bestimmte Fensterfunktionen zum Einsatz. Der störende Leck-Effekt tritt dann auf, wenn der Signalabschnitt nicht periodisch, ein ganzzahliges Vielfaches der Periode oder dieser Signalabschnitt an den Rändern von null verschieden ist. Die Anwendung eines Welch-Verfahrens bei der Identifikation eines Zwei- oder Dreimassensystems ist bereits aus der oben genannten Druckschrift [2] bekannt. Das Welch-Verfahren spaltet *M*-Abtastwerte in *K*-Teilfolgen auf, die mit einer Fensterfunktion gewichtet werden, und auf die eine Fouriertransformation angewendet wird. Die in der Druckschrift [1] beschriebene Welch-Methode ermöglicht die Transformation einer beliebigen Zahl von Abtastwerten mit einer möglichst hohen Genauigkeit in den Frequenzbereich. Hierbei werden die Zeitbereichsdaten gefenstert, die gefensterten Daten in Teilfolgen aufgeteilt und fouriertransformiert, und hieraus Periodigramme ermittelt, die zur Bestimmung der Übertragungsfunktion, in diesem Fall der Admittanz-Funktion, im Frequenzbereich herangezogen werden können.

Alternativ hierzu kann allerdings auch eine Korrelogramm-Methode, die in der Literatur auch unter dem Namen Blackman-Tukey-Schätzung bekannt ist, eingesetzt werden Dabei erfolgt die Spektralschätzung auf Grundlage einer Autokorrelationsfunktion (AKF) und einer Kreuzkorrelationsfunktion (KKF), die aus dem Testsignal (Anregungssignal) und dem Meßsignal (Antwortsignal) berechnet wird. Bei diesem Ansatz erhält man die spektrale Leistungsdichte durch Fourier-Transformation der zuvor geschätzten AKF und KKF. Die Welch-Methode liefert allerdings robustere Ergebnisse.

Ausgehend von der im Frequenzbereich vorliegenden Darstellung einer bekannten Übertragungsfunktion, beispielsweise des Admittanzverlaufs, können die Ersatzschaltbildparameter des Drehstrommotors extrahiert werden. Hierzu gibt es bereits einige numerische Ansätze. Besonders vorteilhaft kann der Levenberg-Marquardt-Algorithmus in einer Weiterbildung der Erfindung verwendet werden, um die Ersatzschaltbildparameter mittels einer Übertragungsfunktionsparameterbestimmung zu identifizieren. Alternativ kann beispielsweise ein Verfahren nach Nelder und Mead verwendet werden, wobei allerdings der Levenberg-Marquardt-Algorithmus, insbesondere bei stark verrauschten Datensätzen, robustere Ergebnisse liefert. Er gehört zur Gruppe von Gradienten-Verfahren, wobei durch iteratives Minimieren einer Fehlerfunktion bessere Parametervektoren berechnet werden können, die den Koeffizienten der Übertragungsfunktion entsprechen. Das Levenberg-Marquardt-Verfahren gilt momentan als Standardverfahren für nicht lineare Optimierungen. Es ist eine Mischung aus Gradienten-Verfahren und Inversion einer Hesse-Matrix und wird in der Literatur auch als Methode des steilsten Abstiegs bezeichnet. Die Inversion der Hesse-Matrix wird auch als Gauss-Newton-Verfahren bezeichnet. In Druckschrift [1] ist eine detaillierte Darstellung der Anwendung des Levenberg-Marquardt-Algorithmus vorgestellt, wobei ausgehend von einer Übertragungsfunktion:

$$G = \underline{Y} = \frac{a_1\, s + a_0}{b_2\, s^2 + b_1\, s + b_0}$$

und unter Vorlage des Frequensgangs des Systems die unbekannten Koeffizienten $a_0$, $a_1$, $b_0$, $b_1$ und $b_2$ bestimmt werden können. Im Vergleich mit der oben genannten Admittanzdarstellung entsprechen diese Koeffizienten den Parametern:

$$a_0 = R_2^{'}, \quad a_1 = L_2, \quad b_0 = R_1 R_2^{'}, \quad b_1 = \left( L_1 R_2^{'} + L_2 R_1 \right), \quad b_2 = \left( L_{1\sigma} L_2 + L_h L_{2\sigma}^{'} \right)$$

Durch die Ermittlung der unbekannten Koeffizienten $a_0$, $a_1$, $b_0$, $b_1$ und $b_2$ lassen sich somit die Ersatzschalt-bildparameter $L_{1\sigma}$, $L_{2\sigma}^{'}$, $L_h$, $R_1$ und $R_2^{'}$ ermitteln.

Gemäß einer vorteilhaften Weiterbildung der Erfindung können die identifizierten Ersatzschaltbildparameter bei einer Einstellung und/oder Optimierung von Wechselrichter-Steuerparametern und/oder zur Motorüberwachung verwendet werden. Bei der Regelung moderner Asynchronmaschinen werden Motorsteuerungsvorrichtungen eingesetzt, die bei schnellen Drehzahlübergängen oder bei Bereitstellung dynamisch regelbarer Abtriebsenergie aufgrund der Kenntnis der elektrischen Ersatzschaltbildparameter entsprechend den Wechselrichter steuern können bzw. die Strangantriebsspannungen derart vorgeben können, dass die Maschine optimal ohne Überschwingen die gewünschten Arbeitsaufgaben erfüllen kann. In diesem Zusammenhang werden die Begriffe Steuerung und Regelung synonym verwendet. Die Kenntnis der Ersatzschaltbildparameter der elektrischen Strecke kann folglich der Parametrierung des Stromreglers dienen, dessen Anforderung an eine hohe Dynamik als innerster Regler am höchsten ist. Insbesondere anspruchsvolle Regelungsverfahren, die über die von konventionellen PI-Reglern hinausgehen, verlangen eine sehr präzise Kenntnis der Maschinenparameter, insbesondere der Ersatzschaltbildparameter. Hierbei sind insbesondere Zustandsraumregler, Dead-Beat-Regler oder Modellfolgeregler zu nennen. Da in jüngster Zeit insbesondere sensorlose Motorsteuerungen eingesetzt werden, können mittels des vorgeschlagenen drehgeberlosen Verfahrens die Ersatzschaltbildparameter von bereits im mechanischen Antriebsstrang integrierten oder ausgetauschten Drehstrommotoren in einer komplexen Maschinenumgebung ermittelt werden, und der Motorregler vor Ort eingestellt werden. Mittels der Ersatzschaltbildparameter ist die Beschreibung des elektrischen Verhaltens während dynamischer Vorgänge möglich, so dass insbesondere bei der Regelung komplexer transienter Übergangsvorgänge der Maschine eine genaue Ansteuerung des Wechselrichters ermöglicht wird. Hierbei wird eine überschwingfreie Reglereinstellung und eine optimiert schnelle Dynamikregelung des Motors ermöglicht. Denkbar ist insbesondere die Anwendung einer solchen optimierten Motorregelung unter genauer Kenntnis der Ersatzschaltbildparameter im Bereich von Druckmaschinen, Kunststoffoberflächen-Herstell- und Bearbeitungsmaschinen oder von Walz- und Verpackungsmaschinen, bei denen dynamikoptimierte Motorsteuerungsverfahren eingesetzt werden müssen. Insbesondere bei Vierfarbdruckmaschinen können kleinste Abweichungen im Farbdruck bei Motorsteuerungsungenauigkeiten erkennbar werden. Bei der Herstellung extrem glatter und dünner Kunststoffoberflächen kann eine gleichmäßige Dicke der Kunststoffschicht nur bei optimaler Dynamikregelung erreicht werden, wobei keine optischen Verunreinigungen des Kunststoffmaterials auftreten können. Während der Analyse der Ersatzschaltbildparameter ruht der Rotor im Stillstand, und kann somit im eingebauten Zustand ohne Einfluss des Antriebsstrangs elektrisch identifiziert werden. Eine Regletparametrierung dient der Optimierung der Steuerpara-meter des Wechselrichters, wobei eine Abweichung der Ersatzschaltbildparameter von beispielsweise vorhergegangenen Messungen zur Fehlerüberwachung des Motors oder zur Verschleißkontrolle berücksichtigt werden kann. Insbesondere kann der Einsatz des Verfahrens im Rahmen eines "Condition Monitoring" des Motors vorteilhaft sein, so dass von Zeit zu Zeit das Verfahren die Ersatzschaltbildparameter neu ermitteln, adaptiv den Motorregler anpassen und bei auffälligen Abweichungen gegenüber zuvor identifizierten oder voreinstellbaren Parameterwerten eine Fehlersignalisierung ausgeben kann, so dass Motor oder Ansteuerelektronik überprüft werden können.

Gemäß eines nebengeordneten Aspekts der Erfindung wird eine Identifikationseinrichtung nach Anspruch 7 vorgeschlagen.

Somit betrifft diese Erfindung eine Identifikationseinrichtung, die dazu ausgelegt ist, ein vorgenanntes Verfahren auszuführen und hierzu die Möglichkeit eröffnet, mittels einer Wechselrichter-Interfaceeinheit mit einer Wechselrichter-Steuereinrichtung, insbesondere mit den Halbleiterschaltbauteilen des Wechselrichters zu kommunizieren, um diese zu schalten bzw. deren Betriebszustand abzufragen. Durch Deaktivierung des Wechselrichters und/oder Aktivierung einer Bremse für eine geraume Zeit kann ein Stillstand des Rotors feststellbar sein. Daneben können beispielsweise Drehzahl- oder Drehgebersensoren Aufschluss über einen Stillstand des Rotors geben. Diese Sensoren werden allerdings nicht zur Parameteridentifikation benötigt, eine heuristische Kenntnis über einen angenommenen Rotorstillstand kann in den meisten Fällen genügen. Die Identifikationseinrichtung umfasst eine Testsignalerzeugungseinrichtung, die ein zweikanaliges identisches $\alpha/\beta$-Testsignal erzeugen kann, wobei das Testsignal, insbesondere ein PRB-Rauschsignal, mittels einer *U/V/W*-Transformationseinheit in ein *U/V/W*-Steuertestsignal umgewandelt werden kann, das der Wechselrichter-Steuereinrichtung zuführbar ist. Das Steuertestsignal erzeugt in dem Motor entsprechende Testsignalspannungen in den drei Motorsträngen. Des Weiteren umfasst die Identifikationseinrichtung eine $\alpha/\beta$-Transformations-einheit, die die gemessenen $I_U$, $I_V$ und $I_W$ -Meßsignalströme in $\alpha/\beta$-Meßsignalströme $I_\alpha$ und $I_\beta$ umwandeln kann und eine Parameteridentifikationseinheit, die ausgehend von der im Zeitbereich vorliegenden Testsignalspannungen $U_\alpha$, $U_\beta$ und gemessenen Meßsignalströme $I_\alpha$, $I_\beta$, eine Parameteridentifikation nach vorgenanntem Verfahren durchführen kann. Eine derartige Identifikationseinrichtung kann beispielsweise mehrteilig aufgebaut sein, wobei zur Erzeugung des Testsignals der Motorkontroller einer Motorsteuervorrichtung verwendet werden kann. Die gemessenen Ströme können ebenfalls von der Motorsteuerungsvorrichtung aufgezeichnet werden. Ein externer Rechner kann diese gemessenen und eingespeisten Spannungen und Ströme auslesen, in den Frequenzbereich transformieren und eine Parameteridentifikation durchführen.

Gemäß einer vorteilhaften Weiterbildung der Identifikationseinrichtung kann die Parameteridentifikationseinheit ein Fouriertransformationsmittel, insbesondere ein FFT/DFT-Mittel zur Fouriertransformation diskontinuierlicher $\alpha/\beta$-Abtast-Signalwerte nach dem Welch-Verfahren und ein Parameterbestimmungsmittel, insbesondere ein Levenberg-Marquardt-Übertragungsfunktions-Parameterbestimmungsmittel umfassen. Demgemäß umfasst die Parameteridentifikationseinheit ein Fouriertransformationsmittel zur Überführung der eingespeisten und gemessenen Spannungs- und Strom-Zeitabtastwerte $U_{1\alpha}$, $U_{1\beta}$, $I_{1\alpha}$, $I_{1\beta}$ und ein Parameterbestimmungsmittel, das ausgehend von im Frequenzbereich vorliegenden Übertragungsfunktionen $G_1$, $G_2$, $G_3$ und/oder $G_4$, eine Bestimmung der Übertragungsfunktionskoeffizienten $a_0$, $a_1$, $b_0$, $b_1$ und $b_2$ vornehmen kann. Die hierzu notwendigen Rechenverfahren können beispielsweise innerhalb eines DSPs, eines Mikrocontrollers eines FPGAs, eines PCs oder eines Kleinrechners durchgeführt werden, wobei eine logische und bauliche Trennung zwischen Testsignalerzeugung, Meßwertspeicherung, Fouriertransformation und Parameterbestimmung möglich ist. Die Signalverarbeitung und das anschließende numerische Verfahren kann vorteilhaft als Softwareimplementierung zumindest teilweise auf einem Motorregler bzw. Motorsteuerungsvorrichtung vorgesehen sein.

So ist denkbar, das Fouriertransformationsmittel als FPGA aufzubauen, um eine schnelle Fouriertransformation mit Hilfe eines statischen Schaltkreises zu realisieren, und das Parameteridentifikationsmittel als variable Rechensoftware auf einem Hochleistungs-DSP eines Motorsteuerreglers zu implementieren. Eine Testsignalerzeugung und Meßwertspeicherung kann innerhalb einer Wechselrichter-Motorsteuerungsvorrichtung durchgeführt werden. Fouriertransformation und Parameteridentifikation kann ebenfalls durch eine Motorsteuerungsvorrichtung oder durch eine externe Identifikationseinrichtung, die ein Interface zur Kommunikation mit der Motorsteuerungsvorrichtung aufweist, erfolgen. Somit kann die Motorsteuerungsvorrichtung mit geringer Rechenleistung ausgerüstet sein, und anspruchsvolle signaltheoretische Aufgaben in einer externen Identifikationseinrichtung, die an die Motorsteuerungsvorrichtung abschließbar ist, abgearbeitet werden, wodurch Hardwareaufwand eingespart werden kann.

Gemäß einer vorteilhaften Weiterbildung kann die Einrichtung des Weiteren eine Überwachungs- und Optimierungseinheit umfassen, die eingerichtet ist, auf Basis der identifizierten Ersatzschaltbildparameter Steuerparameter einer Wechselrichter-Steuereinrichtung zu bestimmen, zu optimieren und/oder zu überwachen. Die Überwachungs- und Optimierungseinheit empfängt die bestimmten Ersatzschaltbildparameter der Parameteridentifikatlonseinheit und kann auf Basis der bestimmten Ersatzschaltbildparameter Steuerungsparameter der Motorsteuervorrichtung optimierten, insbesondere hinsichtlich eines dynamischen Reglerverhaltens und/oder Filtereigenschaften, um die Auswirkungen des induktive Verhaltens des Asynchronmotors auf das Netz zu verringern. Des Weiteren kann ein effizienter Betrieb der Motorsteuerung optimiert und Motorveränderungen überwacht bzw. beim Motorausfall oder Fehlverhalten ein Fehlersignal ausgegeben werden. Die hierzu benötigten Ersatzschaltbildparameter können im Rahmen eines "Condition-Monitoring" durch die Überwachungs- und Optimierungseinheit routinemäßig nach einem bestimmten Zeitintervall oder beispielsweise bei Auswechseln des Motors oder Motorteilen erneut vorgenommen werden.

In einem nebengeordneten Aspekt schlägt die Erfindung eine Motorsteuerungsvorrichtung zur drehgeberlosen Steuerung - bzw. Regelung eines Drehstrom-Asynchronmotors vor, die eine zuvor beschriebene Identifikationseinrichtung zur drehgeberlosen Identifikation elektischer Ersatzschaltbildparameter umfasst, wobei die identifizierten Ersatzschaltbildparameter zur Bestimmung, Optimierung und Überwachung des Motors und/oder der Motorsteuerung verwendbar sind. Somit schlägt dieser Aspekt eine Motorsteuerungs- bzw. Motorregelungsvorrichtung vor, die in üblicher Weise eine sensorbasierte oder drehgeberlöse Steuerung bzw. Regelung des Drehzahlverhaltens des Asynchronmotors vornehmen kann und die eine Identifikationseinrichtung umfasst oder in Verbindung mit einer solchen Identifikationseinrichtung steht, und die die identifizierten Ersatzschaltbildparameter zur Optimierung des Regelverhaltens, zur Bestimmung elektrischer Größen für die Ansteuerung des Motors und für die Überwachung eines fehlerfreien Verhaltens des Asynchronmotors und/oder der Motorsteuerung verwendet. So können die ermittelten Ersatzschaltbildparameter zur optimalen Einstellung von Steuerungskennlinien dienen, so dass ein dynamisches Regelverhalten überschwingfrei ermöglicht werden kann. Somit können die identifizierten Parameter zur Optimierung des Stromverbrauchs und der Energieeffizienz des Asynchronmotors herangezogen werden und beispielsweise für eine Filterparametrierung zur Einstellung elektronischer Filter eingesetzt werden oder sie können zur Überwachung des fehlerfreien Verhaltens der Motorsteuerungsvorrichtung und/oder des Asynchronmotors herangezogen werden. Im Falle eines vorbestimmbaren Abweichens der identifizierten Parameter gegenüber zuvor bestimmen oder vorgegebenen Ersatzshaltbildparametern kann ein Fehlerfall angenommen werden, beziehungsweise eine Neubestimmung der Ersatzschaltbildparameter durchgeführt werden. Im Falle einer Reparatur oder einer Auswechslung des Motors kann die Motorsteuerungsvorrichtung adaptiv die Ersatzschaltbildparameter des neuen Motors identifizieren und sich optimiert auf den neuen Motor einstellen. Eine solche Selbstkalibrierung der Motorsteuerungsvorrichtung kann werksseitig erfolgten, oder beim Einbau der Maschine beim Kunden, beziehungsweise im laufenden Betrieb im Rahmen eines "Condition Monitorings".

In einer vorteilhaften Weiterbildung wird vorgeschlagen, dass die Motorsteuerungsvorrichtung derart eingerichtet ist, dass zumindest bei der erstmaligen Inbetriebnahme, bevorzugt mehrmals im Laufe des Betriebsiebens, eine automatisierte Identifikation der Ersatzschaltbildparameter während eines Rotorstillstande vornehmbar ist, wobei bei einer vorstellbaren Abweichung der identifizierten Ersatzchaltbildparameter von vorherig bestimmen gespeicherten und/oder modellbezogenen Ersatzchaltbildparametern eine Fehlereignalisierung auslösbar ist. Somit schlägt dieser Aspekt vor, dass zumindest bei einer erstmaligen Inbetriebnahme, beziehungsweise einem Testlauf werksseitig, bevorzugt jedoch im Rahmen eines "Condition Monitorings", oder bei Reparatur Oder Austausch von Teilen des Motors eine Parameteridentifikation vorgenommen wird, wobei die Motorsteuerungsvorrichtung zur Optimierung, Einstellung und Überwachung des Motors diese Ersatzschaltbildparameter berücksichtigen kann. Somit kann eine "universelle" Motorsteuerungsvorrichtung geschaffen werden, die sich adaptiv an eine ganze Reihe unterschiedlicher Asynchronmotoren anpassen kann, wobei im Motorstillstand eine Identifikation der elektrischen Größen vornehmbar ist. Alterungsbedingte Veränderungen des Motors können durch eine adaptive Korrektur der Reglerparameter berücksichtigt werden und Fehlfunktionen des Motors oder der Motorsteuerungsüberwachung können erkannt werden.

Schließlich wird in einem nebengeordneten Aspekt der Erfindung eine Verwendung des vorgenannten Verfahrens zur Bestimmung, Optimierung und Überwachung von Motorregelparametern für die Steuerung bzw. Regelung elektrischer Antriebe, insbesondere zur Einstellung von Regelungsparametern einer Motorsteuerungs- bzw. Motorregelungsvorrichtung vorgeschlagen. In diesem Aspekt wird vorgeschlagen, dass die ermittelten Ersatzschaltbildparameter zur Regleroptimierung, Parametrierung und Überwachung eingesetzt werden. Eine Ermittlung der Ersatzschaltbildparameter kann beilspielsweise für eine Baureihe von Asynchronmotoren einmalig an einem Mustermotor vorgenommen werden, und entsprechende Regelparameter für die hiefür eingesetzten Motorsteuerungsvorrichtungen optimiert und angepasst werden. Dies kann werksseitig erfolgen. Ist in einer Motorsteuerungsvorrichtung eine Identifikationseinrichtung vorgesehen oder extern anschließbar, so kann diese im eingebauten Zustand des Motors bei Erstinbetriebnahme, bei Reparaturmaßnahmen oder routinemäßiger oder laufender-Zustandsüberwachung ("Condition Monitoring") eine Neuidentifikation der Parameter vornehmen. Hierzu können Teile des Verfahrens, wie die Frequenzbereichstransformation und die Parameterbestimmung, auf einem externen Rechner ausgeführt werden, und andere Teile, wie beispielsweise die Einspeisung des Testsignals und die Konvertierung vom Dreiphasensystem in das Zweikoordinatensystem, innerhalb der Motorsteuerungsvorrichtung vorgenommen werden. Entscheidend ist jedoch, dass die identifizierten Ersatzschaltbildparameter zur optimalen Reglerperametrierung, Filtereinstellung, elektrischer Bauteildimensionierung verwendbar sind.

Zeichnungen

Weitere Vorteile ergeben sich aus der folgenden Zeichnungsbeschreibung. In der Zeichnung sind Ausführungsbeispiele der vorliegenden Erfindung dargestellt. Die Zeichnung, die Beschreibung und die Ansprüche enthalten zahlreiche Merkmale in. Kompination. Der Fachmann wird die Merkmale zweckmäßigerweise auch einzeln betrachten und zu sinnvollen weiteren Kombinationen zusammenfassen.

Es zeigen beispielhaft:

Fig. 1    ein Ersatzschaltbild einer Statorspule eines Asynchronmotors in Sternschaltung;

Fig. 2    Darstellung des Zusammenhangs zwischen Zweikomponenten- und Dreiphasenkoordinatensystems;

Fig. 3    schematisch ein Aufbau eines Asynchronmotors mit Kurzschlussläufer;

Fig. 4    ein T-Ersatzschaltbild eines Asynchronmotors:

Fig. 5    Rotordrehbewegungen bei Ersatzschaltbildidentifikation nach dem Stand der Technik;

Fig. 6    ein erstes Ausführungsbeispiel einer Motorsteuerungsvorrichtung der Erfindung;

Fig. 7    ein Ausführungsbeispiel einer Motorsteuerungsvorrichtung gemäß der Erfindung;

Fig. 8    ein Ablaufplan eines Ausführungsbeispiels eines erfindungsgemäßen Verfahrens;

Fig. 9    schematisch ein Ausführungsbeispiel einer Testsignaleinspeisung in ein mathematisches Modell eines Asynchronmotors;

Fig.10    Drehmomentverläufe entsprechend den Strömen $I_{\alpha}$ und $I_{\beta}$ bei Anwendung eines Ausführungsbeispiels des erfindungsgemäßen Verfahrens;

**Fig.11**  ein Betrag-Phasenverlauf einer Admittanz aus gemessenen Zeitbereichsdaten bei Anwendung eines erfindungsgemäßen Verfahrens;

**Fig.12**  Vergleich eines gemessenen und exakten Maschinenmodells bei Anwendung eines erfindungsgemäßen Verfahrens;

**Fig.13**  schematisch eine unsymmetrische Testsignaleinspeisung in ein mathematisches Modell eines Asynchronmotors;

**Fig.14**  Drehmomentbeträge aufgrund der unsymmetrisch eingespeisten Ströme $I_\alpha$ und $I_\beta$ bei Einspeisung nach Fig. 13;

**Fig.15**  eine Übertragungsfunktion-Parameterextraktion bei unsymmetrischer Einspeisung nach Fig. 13.

AUSFÜHRUNGSFORMEN DER ERFINDUNG

In den Figuren sind gleiche oder gleichartige Komponenten mit gleichen Bezugsziffern bezeichnet.

Zur Erläuterung der Erfindung zeigt Fig. 1 ein Ersatzschaltbild der Statorspule 01 eines Drehstrommotors. Jeder Spulenstrang $U$, $V$ und $W$ umfasst einen Spulenwiderstand $R_s$ 03 und eine Spuleninduktivität $L_s$ 05. Die drei Spulenstränge 07 sind an ihrem ersten Ende miteinander verbunden und an ihrem zweiten Ende an die drei Phasen $U$, $V$, $W$ des Ausgangs eines Wechselrichters angeschlossen. Die Statorspule 01 interagiert mit der drehbar gelagerten Rotorspule 11, in der bei Einprägung eines sich drehenden Magnetfelds der Statorspule 01 eine Spannung induziert wird, die ein entgegen gerichtetes Rotormagnetfeld erzeugt, durch das sich der Motor in Drehung versetzt. Die Drehzahl des Rotors 11 eilt der Magnetdrehgeschwindigkeit der Statorspule 01 hinterher, wodurch weiterhin Spannung in den Rotor 11 induziert wird. Der Grad des Nacheilens wird als Schlupf s bezeichnet. Das System aus Rotorspule 11 und Statorspule 01 kann statt in einem Drehphasensystem $U/V/W$ in einem Stator-Zweikoordinatensystem $\alpha/\beta$ oder Rotor-Zweikoordinatensystem $d/q$ betrachtet werden, woraus das in Fig. 4 dargestellte T-Ersatzschaltbild des Motors abgeleitet werden kann.

Hierzu zeigt zunächst Fig. 2 die räumliche Zuordnung des Dreiphasensystems $U/V/W$ mit den drei Koordinatenrichtungen 1 (0°), $e^{j2\pi/3}$ (120°) und $e^{j4\pi/3}$ (240°) gegenüber dem $\alpha/\beta$ Koordinatensystem der komplexen Ebene mit Realteil und Imaginärteil. Unter Annahme eines Gesamtstroms $I$ kann dieser in Bezug auf das Dreiphasensystem in drei Teilströme $I_U$, $I_V$ und $I_W$ aufgeteilt werden. In gleicher Weise kann der Strom durch die Teilströme in komplexen statorfesten Koordinatensystem $I_\alpha$ und $I_\beta$ ausgedrückt werden. Die Relation zwischen $I_\alpha$, $I_\beta$ und $I_U$, $I_V$ und $I_W$ sind bereits weiter oben angegeben worden. Unter Verwendung der komplexen Darstellung $I_\alpha$ und $I_\beta$, die die ortsfesten Statorachsenrichtungen angeben und den drei Strangströmen $I_U$, $I_V$ und $I_W$ können die obige Transformationsvorschrift hergeleitet werden. Der Rotor besitzt ein drehendes Koordinatensystem $d/q$, das die Rotor-Flussachse $d$ und Querflussachse $q$ aufweist. Der Zusammenhang zwischen den sich drehenden Koordinaten $d/q$ und den ortsfesten Koordinaten $\alpha/\beta$ kann durch den Rotordrehwinkel $\beta_k$ hergestellt werden.

In Fig. 3 ist schematisch der Aufbau eines Drehstrom-Asynchronmotors 09 dargestellt. Dieser umfasst in einer einfachen Ausführung einen dreiphasigen Stator 13 mit den Spulensträngen U1, U2 (07-U), V1, V2 (07-V) und W1, W2 (07-W). Die ortsfesten Statorspulen definieren drei Spulenachsen A1, A2 und A3, die den in Fig. 2 gezeigten drei Phasenachsen 1, $e^{j2\pi/3}$ und $e^{j4\pi/3}$ entsprechen. Der Rotor 11 umfasst einen Kurzschlussläufer, in dem bei einem sich drehenden Statormagnetfeld Spannung induziert wird, und dessen induzierter Strom ein Gegenmagnetfeld erzeugt, wodurch ein Drehmoment des Motors 09 erzeugt wird.

Schließlich zeigt Fig. 4 das Ersatzschaltbild der Verkopplung von Stator- und Rotorspulen mit den Strangströmen $I_1$, $I_2$ und $U_1$, $U_2$ wobei der Index 1 für die Statorspule und der Index 2 für die Rotorspule steht. Das Ersatzschaltbild nach Fig. 4 ist ein T-Ersatzschaltbild und beschreibt den elektrischen Zusammenhang zwischen Statorspule 01 mit $R_1$, $L_{1\sigma}$ 03, 05 und Hauptinduktivität $L_h$ zum Rotor 11 und die Wirkung der Rotorspule mit $R'_2$ und $L'_{2\sigma}$ sowie ebenfalls mit Hauptinduktivität $L_h$. Auf Basis des T-Ersatzschaltbilds kann unter der Annahme eines Schlupfs=1 folgende Admittanzfunktion hergeleitet werden:

$$G = \underline{Y} = \frac{s\, L_2 + R'_2}{s^2\left(L_{1\sigma}\, L_2 + L_h\, L'_{2\sigma}\right) + s\left(L_1\, R'_2 + L_2\, R_1\right) + R_1\, R'_2}$$

Aufgabe der vorliegenden Erfindung ist es nun, die in Fig. 4 dargelegten Ersatzschaltbildgrößen $R_1$, $R'_2$, $L_{1\sigma}$,

$L'_{2\sigma}$ und $L_\mathrm{h}$ zu bestimmen. Ausgehend von der Kenntnis dieser Ersatzschaltbildgrößen kann bei eingespeisten Spannungen $U_\alpha$, $U_\beta$ die sich einstellenden $I_\alpha$, $I_\beta$ vorhergesagt werden, wobei gewünschte Drehzahlen und Drehmomente durch Einstellung der Regelparameter optimiert werden können. Wesentlich dabei ist eine Beschreibung des transienten Verhaltens, wobei eine einzige Analyse des elektrischen Verhaltens des Motors eine möglichst genaue Kenntnis über die Ersatzschaltbildparameter liefert.

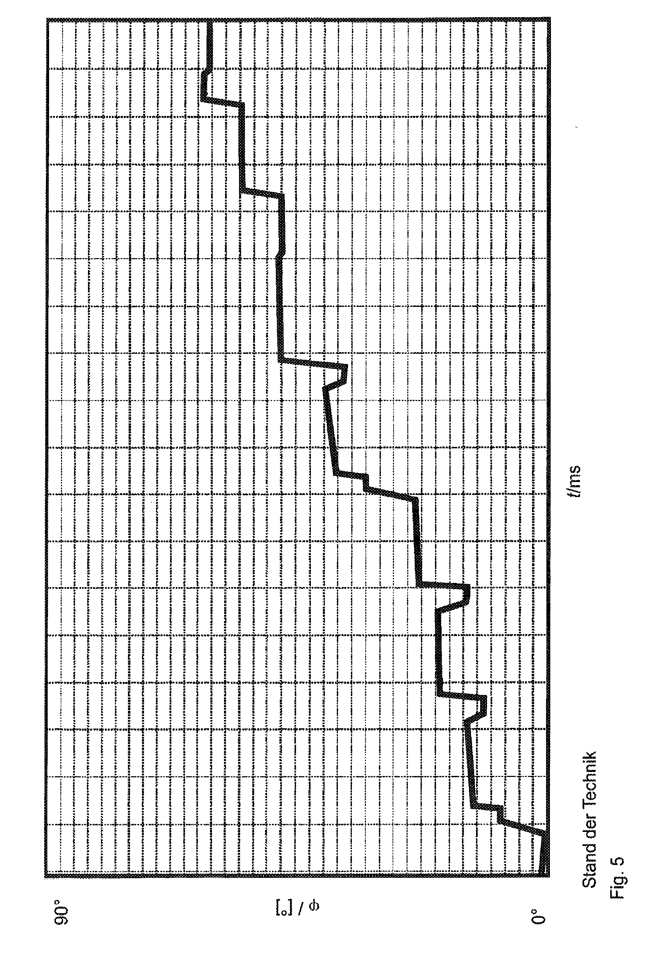

Aus dem Stand der Technik sind Kurzschluss-, Leerlauf- und Gleichstromversuche bekannt, um diese Ersatzschaltbildparameter zu identifizieren. So zeigt Fig. 5 in einer aus dem Stand der Technik bekannten Motorsteuerungsvorrichtung b_maXX 5000 der Firma Baumüller Nürnberg GmbH das Verhalten des Rotordrehwinkels φ über der Zeit bei der Identifikation der vorgenannten Parameter mit Hilfe eines implementierten reinen Zeitbereichsverfahrens. Dabei führt der Motor deutliche mechanische Bewegungen aus. Ist der Motor an einem mechanischen Antriebsstrang gekoppelt, so beeinflusst dieser die Rotorbewegung, so dass das Ergebnis verfälscht wird. Im Ergebnis können Ersatzschaltbildparameter bei eingebautem Zustand eines Motors nicht ermittelt werden. Des Weiteren sind zusätzliche Leerlauf- und Kurzschlussversuche notwendig, um eine exakte Kenntnis der Ersatzschaltbildparameter zu gewinnen, wobei hohe mechanische und elektrische Belastungen des Motors auftreten können, die eine Beschädigung oder Zerstörung des Motors bewirken können.

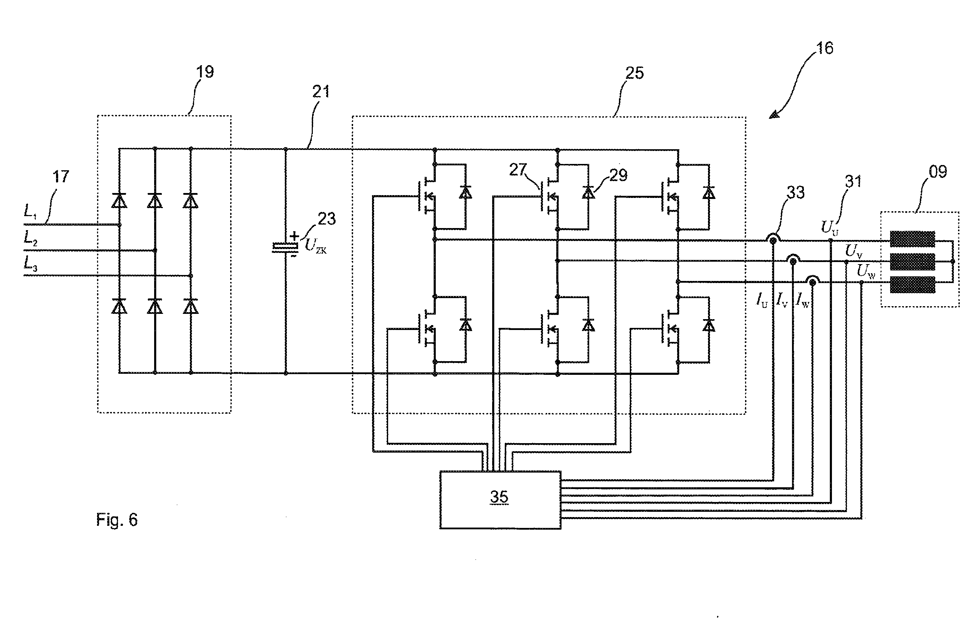

Fig. 6 zeigt schematisch eine Motoransteuerschaltung 16, bei der die Phasen eines Drehstromversorgungsnetzes 17 mittels eines Dreiphasen-Brückengleichrichters 19 in eine Gleichspannung eines DC-Zwischenkreises 21 umgewandelt werden. Im DC-Zwischenkreis 21 ist ein Pufferkondensator 23 vorgesehen, der die Spannung glättet und beispielsweise bei Stromausfall Pufferenergie für einen geregelten Notfahrbetrieb des Motors 09 zur Verfügung stellen kann. Ein Wechselrichter 25 umfasst drei Schaltbrücken, in denen Leistungshalbleiter-Schaltelemente 27 die Motorstränge $U/V/W$ gegenüber der Gleichspannung +DC und -DC des Zwischenkreises 21 koordiniert schalten können, und somit drehzahlvariabel eine PWM-modellierte Ansteuerspannung $U_\mathrm{u}$, $U_\mathrm{v}$, $U_\mathrm{w}$ für den Drehstrommotor 09 bereitstellen. Jedes Leistungshalbleiterschaltelement 27, das ein IGBT-Transistor, ein Leistungstransistor oder Ähnliches umfassen kann, ist mittels einer Freilaufdiode 29 gegen Überspannung, insbesondere induktive Rückwirkung durch den Motor 09, geschützt. Die Strangspannungen $U_\mathrm{u}$, $U_\mathrm{v}$, $U_\mathrm{w}$ 31 sowie Strangströme $I_\mathrm{u}$, $I_\mathrm{v}$, $I_\mathrm{w}$ 33 werden in den Zuführleitungen zu dem Drehstrommotor 09 abgegriffen, und einer Motorsteuerungsvorrichtung 35 zugeführt. Die Strangspannungen müssen nicht notwendigerweise abgegriffen werden, da diese vom Wechselrichter 25 vorgegeben werden können und angenommen wird, dass der vorgegebene Spannungssollwert gleich dem Spannungsistwert ist.

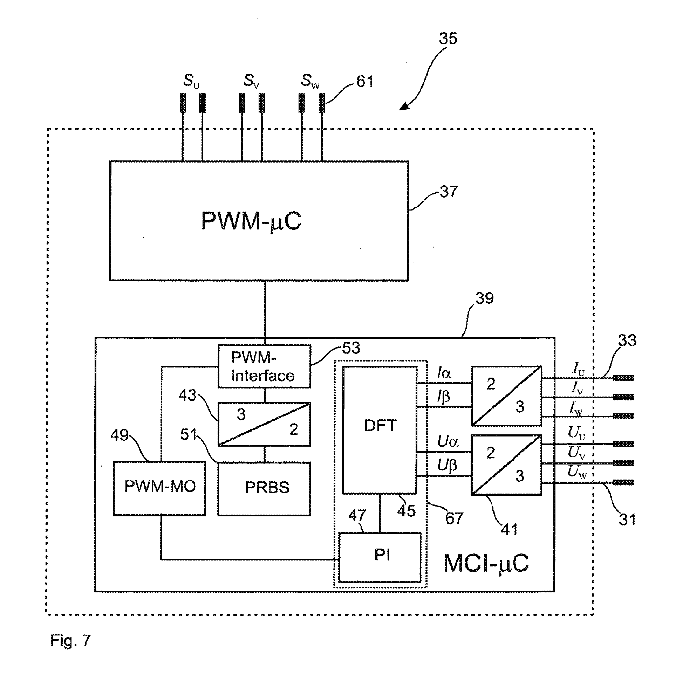

Die Motorsteuerungsvorrichtung 35 umfasst Steuerleitungen, um die einzelnen Leistungshalbleiterschaltelemente 27 je nach gewünschtem Drehzahlverhalten des Motors 09 phasenrichtig anzusteuern. Im Falle einer sensorbasierten Regelung ist die Motorsteuerungsvorrichtung 35 des Weiteren mit Positionswinkel- und Beschleunigungssensoren gekoppelt, wobei auch Temperatursensoren zur Überwachung der Betriebstemperatur des Motors 09 angeschlossen werden können. Im Falle einer drehgeberlosen feldorientierten Regelung kann die Motorsteuerungsvorrichtung 35 lediglich durch Kenntnis der Strangspannungen 31 und gemessenen Strangströmen 33 eine drehzahloptimierte Ansteuerung der Wechselrichter-Schaltbauteile 27 vornehmen. Die Regelparameter der Motorsteuerungsvorrichtung 35 können durch Kenntnis des elektrischen Verhaltens des Motors 09, der sich durch das in Fig. 4 dargestellte Ersatzschaltbild beschreiben lässt, eingestellt werden. Hierzu umfasst die Motorsteuerungsvorrichtung 35 eine Identifikationseinrichtung 39, wie sie in Fig. 7 dargestellt ist.

In der Fig. 7 ist ein Ausführungsbeispiel einer Motorsteuerungsvorrichtung 35 dargestellt, die eine Identifikationseinrichtung 39 zur Extraktion der Ersatzschaltbildparameter des Drehstrom-Asynchronmotors 09 umfasst. Die Motorsteuerungsvorrichtung 35 weist Eingänge zur Erfassung der drei Strangströme $I_\mathrm{U}$, $I_\mathrm{V}$ und $I_\mathrm{W}$ 33 sowie der drei Strangspannungen $U_\mathrm{U}$, $U_\mathrm{V}$ und $U_\mathrm{W}$ 31des Drehstrommotors 09 auf, wobei eine Erfassung von nur zwei Strangspannungen und Strangströmen genügt, da sich die dritte Größe nach Kirchhoff ergibt. Des Weiteren umfasst die Motorsteuerungsvorrichtung 35 Schaltausgänge 61 zur Ausgabe von Wechselrichter-Schaltsignalen zur Betätigung der Leistungshalbleiter-Schaltelemente 27 des Wechselrichters 25. Die phasenrichtige Erzeugung der Wechselrichter-Schaltsignale 61 erfolgt mittels eines PWM (Pulse-Width Modulation)-Mikrocontrollers, der eine Wechselrichter-Steuereinrichtung 37 darstellt, um sensorlos oder auch sensorgestützt eine Drehzahl- und Drehmomentregelung des Drehstrommotors 09 vorzunehmen. Die Identifikationseinrichtung 39 empfängt die Strangspannungen 31 und Strangströme 33 und umfasst eine $\alpha/\beta$-Transformationseinheit 41, die Strangspannungen und Strangströme in die Teilspannung $U_\alpha$, $U_\beta$ sowie Teilströme $I_\alpha$, $I_\beta$ des komplexen Zweikoordinatensystems umwandelt. Die umgewandelten Strangspannungen und Strangströme werden in eine Parameteridentifikationseinheit 67 eingespeist, die zum einen ein Fouriertransformationsmittel 45 und zum anderen ein Parameterextraktionsmittel 47 umfasst. Auf die Zeitbereichsdaten der Strangspannungen und Strangströme wird eine Fouriertransformation angewendet, so dass diese Daten im Frequenzbereich vorliegen und oben definierte Admittanz-Übertragungsfunktionen $G_1$, $G_2$, $G_3$ oder $G_4$ gebildet werden können. Anstelle der Admittanzfunktion können Koeffizienten einer anderen Übertragungsfunktion, insbesondere Impedanzfunktion oder andere sinnvolle elektrische Funktionsbeziehungen zugrunde gelegt und auf dieser Basis die interessierenden Parameter bestimmt werden. Ausgehend von den Verläufen der Übertragungsfunktionen kann die Parameteridentifikationseinheit 67 des Parameterextraktionsmittels 47 unter Kenntnis der zugrunde liegenden Admittanz-Beschreibungsfunktion die zu identifizierende Koeffizienten aus den Kurvenverläufen extrahieren. Hieraus können die Ersatzschaltbildparameter $R_1$, $R'_2$, $L_{1\sigma}$, $L'_2$ a und $L_h$ des in Fig. 4 dargestellten Ersatzschaltbilds ermittelt werden, und auf deren Basis kann eine Optimierungseinheit 49, die eine Modulierung des Motors sowie eine Optimierung von Parametereinstellungen der Pulsweitenerzeugung vornehmen kann, Steuerparameter sowie Filterparameter für die Parametrierung, Optimierung und Überwachung der Wechselrichter-Steuereinrichtung 37 erzeugen. Diese werden an ein PWM-Interface 53 weitergeleitet und können somit an die Wechselrichter-Steuereinrichtung 37 übermittelt werden, um eine optimale Regelung des Asynchronmotors zu ermöglichen.

Im Rahmen der Parameterextraktion werden Testsignale eingespeist, die über eine Testsignalerzeugungseinheit 51 generiert werden können. In diesem Ausführungsbeispiel wird als Testsignal ein Pseudo-Rausch-Binär-Signal (PRBS) erzeugt, das mittels einer $U/V/W$-Transformationseinheit 43 das Rauschsignal gleichmäßig als $U_\alpha/U_\beta$ bereitstellt und auf die drei Strangspannungen $U_U$, $U_V$ und $U_W$ verteilt wird. Dieses Eingangssignal wird an die Wechselrichter-Steuereinrichtung 37 weitergeleitet, die entsprechend den Wechselrichter 25 so steuert, dass der Motor 09 entsprechend dem Testsignal bestromt wird.

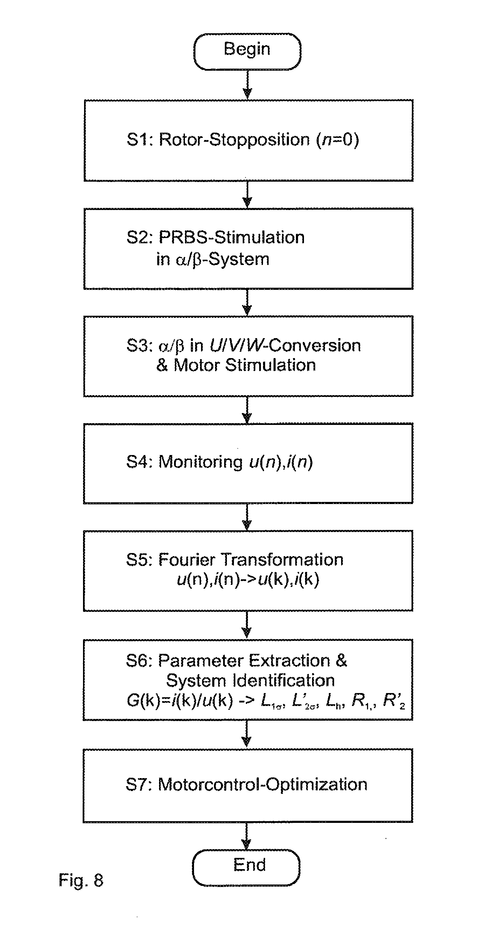

In der Fig. 8 ist ein Ausführungsbeispiel eines Programmablaufplans zur Durchführung eines erfindungsgemäßen Verfahrens dargestellt. In Schritt S1 wird zunächst der Rotor in eine Stillstandslage gebracht, bei der die Umdrehungszahl $n$ gleich 0 beträgt. In Schritt S2 wird die Einspeisung eines Testsignals als PRB-Signal im $\alpha/\beta$-System in beide Kanäle gleichermaßen, also nicht phasenverschoben, oder mit negativem Vorzeichen vorgenommen. Dies ist eine wesentliche Voraussetzung, so dass keine Drehmomente des Rotors auftreten können. Aus den $\alpha/\beta$-Testsignalen wird eine Konversion in die Strangspannungen $U_U$, $U_V$ und $U_W$ durchgeführt und damit der Motor angesteuert. Die angesteuerten Spannungssignale $U(n)$ sowie die gemessenen Stromwerte $I(n)$ werden im Zeitbereich abgetastet und mittels einer Fouriertransformation, insbesondere einer DFT (Diskreten Fourier Transformation) oder FFT (Fast Fourier Transformation) unter Verwendung einer Welch-Methode, in den Frequenzbereich, d.h. in diesem Fall in den Laplace-Bereich überführt, so dass sich die Frequenzbereichswerte $U(k)$, $I(k)$ ergeben. Im Laplace-Bereich kann eine Übertragungsfunktion der Admittanz dargestellt werden als

$$G(\mathrm{k}) = I(\mathrm{k})/U(\mathrm{k}),$$

die die Ausgangsbasis für die Parameterextraktion bildet. Unter Kenntnis der Übertragungsfunktion kann mittels einer Systemidentifikation eine Parameterextraktion, beispielsweise aufbauend auf den Levenberg-Marquardt-Algorithmus durchgeführt werden, um die Übertragungsfunktionskoeffizienten $a_0$, $a_1$, $b_0$, $b_1$ und $b_2$ aus dem Kurvenverlauf zu ermitteln. Hieraus können die Werte der Ersatzschaltbildparameter $R_1$, $R'_2$, $L_{1\sigma}$, $L'_{2\sigma}$ und $L_h$ abgeleitet werden, und zur Einstellung von Motorsteuerungsparametern, zur Optimierung von Lastwechseln oder Drehmomentwechseln und zur Einstellung und Auslegung von Filterparametern für ein Filtern von Motorströmen oder Motorspannungen herangezogen werden. Durch die Kenntnis der Ersatzschaltbildparameter der elektrischen Strecke kann eine Parametrierung der Wechselrichter-Steuereinrichtung 37 vorgenommen werden, wobei eine hohe Dynamik des Motorverhaltens durch Optimierung des Regelverhaltens der Wechselrichter-Steuereinrichtung als innerster Regler erreicht werden kann. Dabei können anspruchsvolle Regelungsverfahren, die weit über die Möglichkeiten eines konventionellen PI-Reglers des Asynchronmotors hinausgehen, erreicht werden, da eine präzise Kenntnis der elektrischen Maschinenparameter vorliegt. Insbesondere können die Reglerparameter für einen Zustandsraumregler, einen Dead-Beat-Regler oder einer Modellfolgeregelung exakt eingestellt werden.

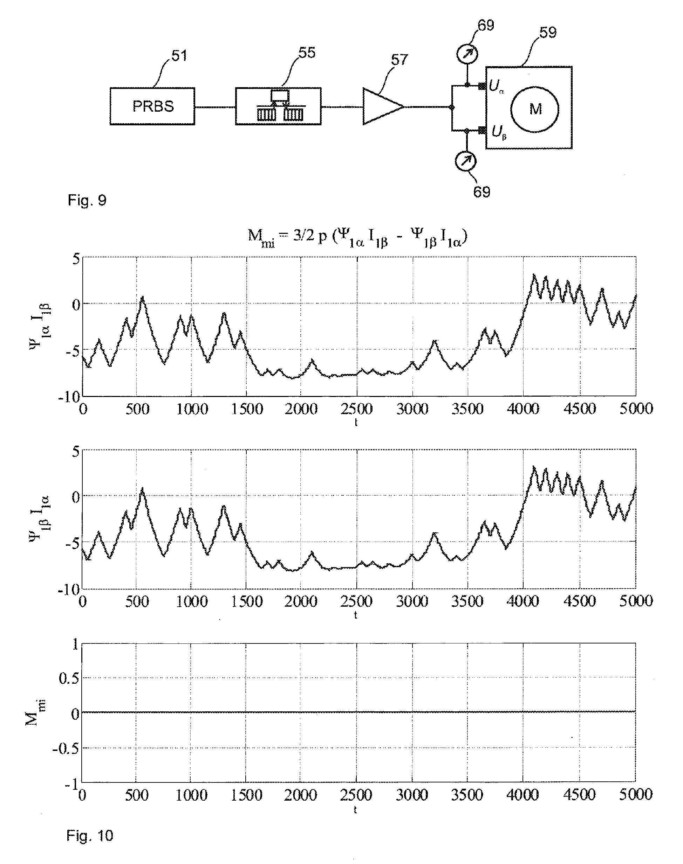

In der Fig. 9 ist schematisch die Einspeisung eines Testsignals einer TestsignalErzeugungseinheit 51 in ein mathematisches Modell eines Drehstrommotors 59 als $\alpha/\beta$-Modell im Rahmen einer Matlab-Simulink Simulation dargestellt. Die TestsignalErzeugungseinheit 51 erzeugt ein Pseudo-Rausch-Binärsignal, das im Takt einer Wechselrichter-Steuereinrichtung 37, die im Regelfall mit 16 kHz Taktrate, d.h. 62.5 μs Taktdauer arbeitet, bereitgestellt wird. Da das $\alpha/\beta$-Motormodell 59 mit quasi analogen Signalen modelliert werden kann, ist eine Abtasterhöhungseinheit 55 zwischengeschaltet, die aus dem grob abgetasteten 16 kHz Testsignal ein quasi kontinuierliches Testsignal erzeugt. Dieses wird durch einen Testsignalverstärker 57 verstärkt und gleichsinnig ohne Phasenversatz und ohne Vorzeichenwechsel als Motorspannung $U_\alpha/U_\beta$ in das $\alpha/\beta$-Asynchronmotormodell 59 eingespeist. Eine Simulation erfolgt dabei mit Matlab-Simulink, um eine mathematische Verifikation des Verfahrens durchzuführen. Die auftretenden Drehmomente lassen sich nach der Formel

$$M_{mi} = \frac{3}{2}\, p \, \Im\!\left\{ \bar{\Psi}_1^{s*}\ \bar{I}_1^{s} \right\}$$

$$M_{mi} = \frac{3}{2}\,p\;\Im\!\left\{\left(\Psi_{1\alpha} + j\,\Psi_{1\beta}\right)^{*}\cdot\left(I_{1\alpha} + j\,I_{1\beta}\right)\right\}$$

$$M_{mi} = \frac{3}{2}\,p\,\left(\Psi_{1\alpha}\,I_{1\beta} - \Psi_{1\beta}\,I_{1\alpha}\right)$$

bestimmen. Ausgehend von der numerischen Simulation werden die Verläufe der Strangströme und die magnetische Verkettung der beiden Teile der obigen Drehmoment-Berechnungsvorschrift durch eine Signalaufzeichnungseinheit 69 aufgezeichnet, woraus sich ein resultierendes Drehmoment von 0 ergibt. Dementsprechend kann gefolgert werden, dass bei den dem Verfahren zugrunde liegenden Ausgangsgleichungen ein stillstehender drehmomentfreier Rotor bei gleichsinniger Einspeisung des Testsignals zu erwarten ist.

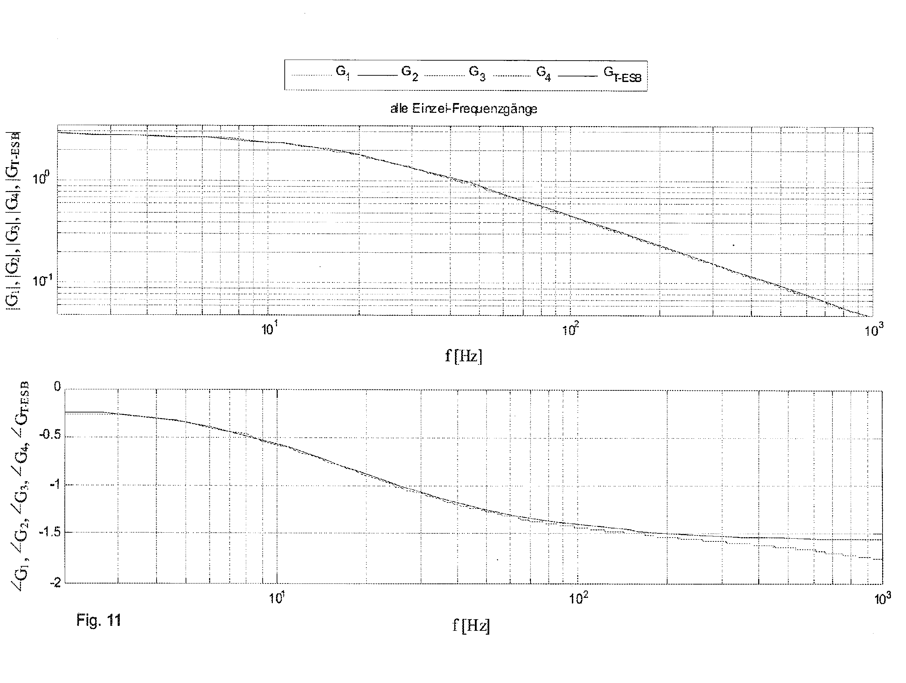

In Fig. 11 ist ein Betrags- und Phasenverlauf über einen Frequenzbereich von 0-1 kHz der Admittanz-Funktion $G=\underline{Y}$, die aus dem identifizierten elektrischen System und aus den exakten Maschinenmodell abgeleitet wurde, dargestellt. Deutlich ist zu erkennen, dass die Übertragungsfunktionen $G_1$ bis $G_4$ nahezu identisch mit dem exakten Maschinenmodell übereinstimmen. Somit kann mittels numerischer Simulation eine Verifikation des theoretischen Modells nachgewiesen werden. Ausgehend von dem im Zeitbereich gemessenen abgetasteten Strangspannungen und Strangströmen kann eine nahezu identische Systemcharakterisierung des elektrischen Verhaltens des Drehstrommotors 09 abgeleitet werden.

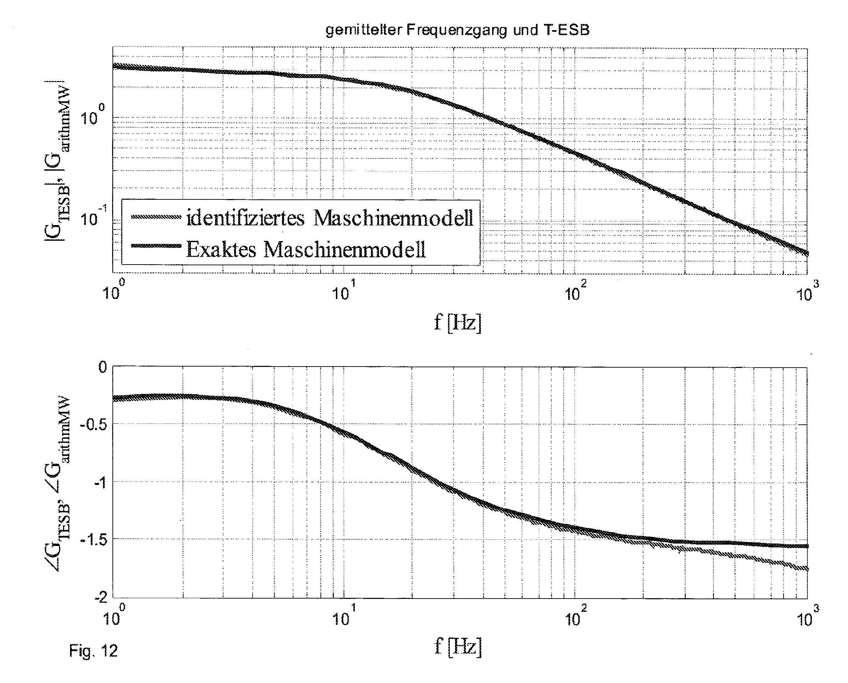

In der Fig. 12 ist nochmals ein Betrags- und Phasenverlauf eines gemittelten Maschinenmodells, das die Betrag- und Phasenverläufe der einzelnen Übertragungsfunktionen $G_1$ bis $G_4$ zusammengefasst mittelt gegenüber dem exakten Maschinenmodell, dargestellt. Lediglich im obersten Frequenzbereich nahe 1 kHz ergeben sich im Phasenverlauf geringe Abweichungen, wobei der Betragsverlauf $|G|$ perfekt übereinstimmt. Aus diesem Grund ist es vorteilhaft, alle vier Übertragungsfunktionen $G_1$ bis $G_4$ zu bestimmen, und eine gegebenenfalls gewichtete Mittelung vorzunehmen, um etwaige Fehler, beispielsweise Ungenauigkeiten der Fouriertransformation oder Parameterextraktion auszugleichen.

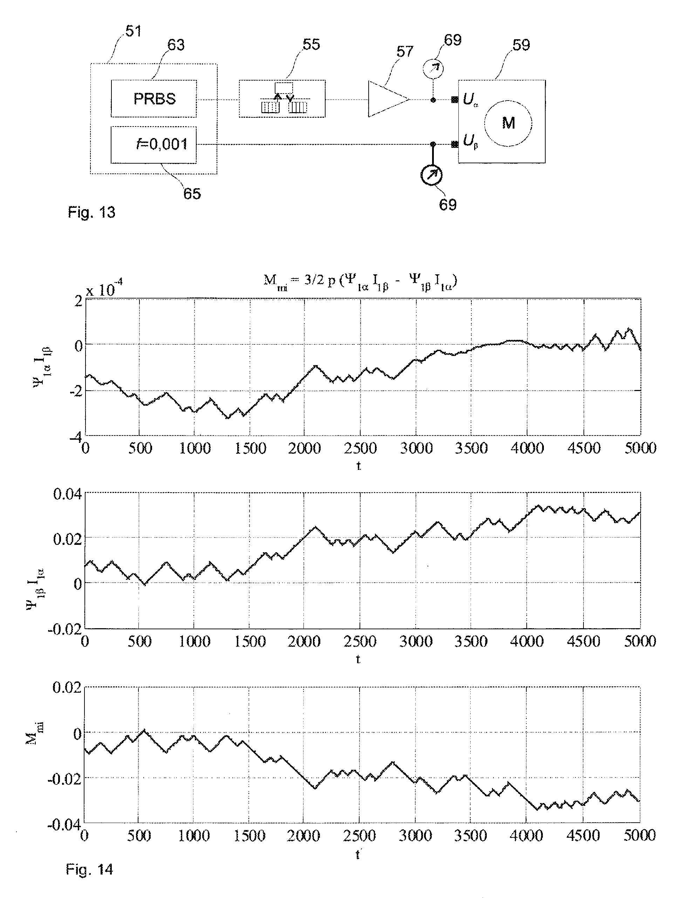

Als Gegenbeispiel zu einer symmetrischen Einspeisung ist in Fig. 13 die Einspeisung eines Testsignals einer Testsignalerzeugungseinheit 51 nur in den $\alpha$-Kanal vorgestellt, während im $\beta$-Kanal ein nahezu konstanter Gleichspannungssignal eingespeist wird. Hierzu umfasst die Testsignalerzeugungseinheit 51 ein $\alpha$-Testsignalerzeugungsmittel 63 und $\beta$-Testsignalerzeugungsmittel 65. Das $\alpha$-Testsignalerzeugungsmittel 63 erzeugt ein Pseudo-Rausch-Binär-Signal, das mit einer typischen Taktfrequenz einer Wechselrichter-Steuerungseinrichtung 37 mit 16 kHz bereitgestellt wird und mittels einer Abtastratenerhöhungseinheit 55 auf ein quasi zeitkontinuierliches Signal umgewandelt wird, wobei eine Verstärkung des Signals mittels eines Testsignalverstärkers 57 nachgeschaltet ist. Den zeitlichen Verlauf des Testsignals und der Signalströme wird mittels einer Signalaufzeichnungseinheit 69 erfasst. Das PRB-Signal wird als Spannung $U_\alpha$ in das mathematische Modell des Drehstrommotors 59 eingespeist. Parallel hierzu erzeugt das $\beta$-Testsignalerzeugungsmittel 65 eine Konstantspannung, die als $U_\beta$ in das Modell des Drehstrommotors 59 eingespeist wird.

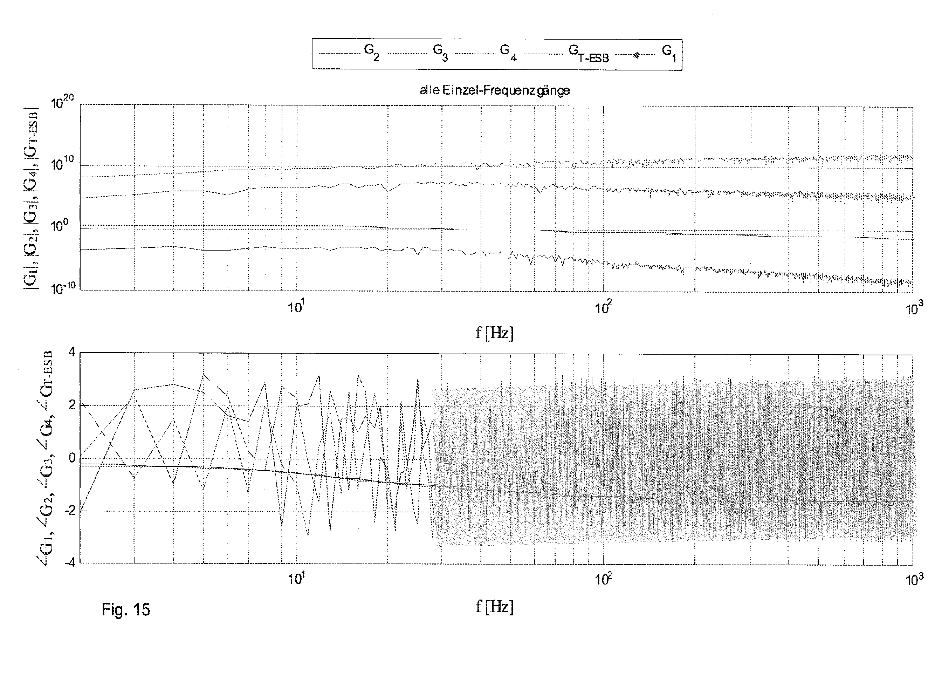

In Fig. 14 sind die beiden Teilprodukte der Drehmomentgleichung sowie das Gesamtdrehmoment, mit dem der Rotor angetrieben wird, dargestellt. Deutlich ist zu erkennen, dass in Falle einer unsymmetrischen Einspeisung der Testsignale ein Drehmoment erzeugt wird, das den Rotor 11 in Drehung versetzt, wobei in diesem Fall eine Parameteridentifikation auch von der Art des mechanischen Antriebsstrangs abhängen würde. Schließlich zeigt Fig. 15 die Auswertung der Übertragungsfunktion bzw. Admittanzen $G_1$ bis $G_4$, die jeweils völlig unterschiedliche Werte liefert, wobei die Phasen- und Betragsverläufe praktisch unbrauchbar sind. Somit ist dargelegt, dass lediglich eine gleichsinnige Einspeisung des Testsignals in beide Koordinatenrichtungen $\alpha$ und $\beta$ des Motors 09 zu verwertbaren Ergebnissen führt.

Die grundsätzliche Idee der Erfindung beruht auf einer signaltheoretischen Betrachtung eines Drehstrom-Elektromotors in einem Zweikoordinatenraum $\alpha/\beta$, wobei mittels symmetrischer Einspeisung eines breitbandigen Testsignals, bevorzugt eines PRB-Signals, Auswertesignale, die als Motorströme vorliegen, in den Frequenzbereich mittels bevorzugt eines Welch-Verfahrens transformiert werden können. Aufbauend darauf können Übertragungsfunktionen aus den eingespeisten und gemessenen Signalen extrahiert werden und mittels einer Parameteridentifikationsmethode, bevorzugt einem Levenberg-Marquardt-Algorithmus, die zugrunde liegenden Systembeschreibungsparameter ausgewertet werden. Durch Kenntnis des formelmäßigen Zusammenhangs der Übertragungsfunktion können die einzelnen Funktionsparameter identifiziert und damit das elektrische Verhalten des Motors charakterisiert werden. Besonderen Schwerpunkt legt die Erfindung auf die besondere Einspeisungsart, die Struktur der Übertragungsfunktion und die Analysevorschrift, bei der im Stillstand des Rotors eine Bestimmung der elektrischen Ersatzschaltbildgrößen ermöglicht wird. Das Verfahrens bildet das transiente Verhalten des Motors über einen großen Arbeitsfrequenzbereich bzw. Drehzahlbereich ab und kann zur Einstellung, Optimierung und Überwachung des Motors verwendet werden. Insbesondere bei Einsatz in einer Motorsteuerungsvorrichtung kann eine universelle Motorsteuerungsvorrichtung bereitgestellt werden, die adaptiv werksseitig oder nach Einbau des Motors bei Verkopplung mit einem mechanischen Abtriebsstrang zur Bestimmung des Motorverhalten benutzt werden kann. Eine motorschonende und schnelle Bestimmung der maschinenbeschreibenden Parameter wird dadurch ermöglicht. Das Verfahren kann softwaretechnisch in bestehenden Motorsteuerungsvorrichtungen wie beispielsweise den Baumüller b_maXX-Motorsteuerungen und Servoregler, insbesondere b_maXX 1000-5000 nachgerüstet werden und eröffnet eine automatisierte Identifikation und Überwachung der motorbeschreibenden Parameter.

**Bezugszeichenliste**

| | |
|---|---|
| 01 | Statorspulen-Ersatzschaltbild eines Asynchronmotors |
| 03 | Spulenwiderstand |
| 05 | Spuleninduktivität |
| 07 | U/V/W-Spulenstrang |
| 09 | Asynchronmotor |
| 11 | Rotor mit Kurzschlussspule |
| 13 | Stator |
| 15 | Ersatzschaltbild einer Ständerspule eines Asynchronmotors |
| 16 | Motoransteuerschaltung |
| 17 | AC-Versorgungsnetz |
| 19 | Dreiphasen-Brückengleichrichter |
| 21 | DC-Zwischenkreis |
| 23 | Pufferkondensator |
| 25 | Wechselrichter |
| 27 | Leistungshalbleiter-Schaltelement |
| 29 | Freilaufdiode |
| 31 | Strangspannung |
| 33 | Strangstrom |
| 35 | Motorsteuerungsvorrichtung |
| 37 | Wechselrichter-Steuereinrichtung |
| 39 | Identifikationseinrichtung |
| 41 | $\alpha/\beta$-Transformationseinheit |
| 43 | U/V/W-Transformationseinheit |
| 45 | Fouriertransformationsmittel |
| 47 | Parameterbestimmungsmittel |
| 49 | Optimierungseinheit |
| 51 | Testsignal-Erzeugungseinheit |
| 53 | Wechselrichtersteuerungs-Interfaceeinheit |
| 55 | Abtastratenerhöhungseinheit |
| 57 | Testsignalverstärker |
| 59 | $\alpha/\beta$-Asynchronmotor-Modell |
| 61 | Wechselrichter-Schaltsignale |
| 63 | $\alpha$-Testsignal-Erzeugungsmittel |
| 65 | $\beta$-Testsignal-Erzeugungsmittel |
| 67 | Parameteridentifikationseinheit |
| 69 | Signalaufzeichnungseinheit |

**Patentansprüche**

1. Verfahren zur drehgeberlosen Identifikation elektrischer Ersatzschaltbildparameter (03, 05, 15) eines Drehstrom-Asynchronmotors (09), wobei es
   zumindest umfasst den Schritt.

   - Einnahme einer Stillstandslage des Rotors (11), **gekennzeichnet dadurch, dass** es zumindest umfasst die Schritte:
   - Identische Testsignalspannungseinspeisung ($U_{1\alpha}$, $U_{1\beta}$) in $\alpha$- und $\beta$-Statorachsenrichtung als Koordinatenrichtung eines komplexen Zweikoordinatensystems des Dreiphasensystems des Asynchronmotors (09);

- Meßsignalstrommessung ($I_{1\alpha}$, $I_{1\beta}$) der $\alpha$- und $\beta$-Achsenrichtung des Asynchronmotors (09);
- Identifikation von Ersatzschaltbildparametern (03, 05, 15) des Asynchronmotors (09) auf Basis der Testsignalspannungen ($U_{1\alpha}$, $U_{1\beta}$) und der digital erfassten zeitlichen Abtastwerte der Meßsignalströme ($I_{1\alpha}$, $I_{1\beta}$) durch Analyse des Frequenzgangs der gemessenen Übertragungsfunktion unter Kenntnis der Übertragungsfunktion im Frequenzbereich eines Ersatzschaltbildes eines Asynchronmotors mittels Parameterextraktion;

wobei die Testsignaleinspeisung in den Asynchronmotor (09) derart erfolgt, dass der Rotor (11) drehmomentfrei bleibt.

2. Verfahren nach Anspruch 1,
**dadurch gekennzeichnet,**
**dass** zumindest eine, insbesondere alle Frequenzgangfunktionen $G_1 = I_{1\alpha}/U_{1\alpha}$, $G_2 = I_{1\beta}/U_{1\alpha}$, $G_3 = I_{1\alpha}/U_{1\beta}$, $G_4 = I_{1\beta}/U_{1\beta}$ zur Identifikation von Ersatzschaltbildparametern (03, 05, 15) ermittelt werden, wobei vorbestimmbare Abweichungen der Frequenzgangfunktionen eine Wiederholung des Verfahrens oder eine Fehlersignalisierung bewirken.

3. Verfahren nach einem der vorangegangenen Ansprüche,
**dadurch gekennzeichnet,**
**dass** das Testsignal ein Pseudo-Rausch-Binär-Signal ist.

4. Verfahren nach einem der vorangegangenen Ansprüche,
**dadurch gekennzeichnet,**
**dass** die Identifikation der Ersatzschaltbildparameter (03, 05, 15) eine Fouriertransformation von zeitdiskreten Signalen nach einem Welch-Verfahren umfasst.

5. Verfahren nach einem der vorangegangenen Ansprüche,
**dadurch gekennzeichnet,**
**dass** die Identifikation der Ersatzschaltbildparameter (03, 05, 15) eine Übertragungsfunktion-Parameterbestimmung insbesondere nach einem Levenberg-Marquardt-Algorithmus umfasst.

6. Verfahren nach einem der vorangegangenen Ansprüche,
**dadurch gekennzeichne**t,
dass die identifizierten Ersatzschaltbildparameter (03, 05, 15) bei einer Einstellung und/oder Optimierung von Wechselrichter-Steuerparametern und/oder zur Motorüberwachung verwendet werden.

7. Identifikationseinrichtung (39) zur drehgeberlosen Identifikation elektrischer Ersatzschaltbildparameter (03, 05, 15) eines Drehstrom-Asynchronmotors (09), der von einer eine Wechselrichter-Steuereinrichtung (37) enthaltenden Steuerung (35) gesteuert ist, **gekennzeichnet** t **dadurch,**
dass die Identifikationseinrichtung (39) des Weiteren eine Wechselrichter-Interfaceeinheit (53), die zur steuernden Kommunikation und zur Rotorstillstandsbestimmung mit der Wechselrichter-Steuereinrichtung (37) verbindbar ist, eine Testsignalerzeugungseinrichtung (51) zur Erzeugung und identischen Einspeisung in $\alpha$- und $\beta$-Statorachsenrichtung als Koordinatenrichtung eines komplexen Zweikoordinatensystems des Dreiphasensystems des Asynchronmotors (09) eines $\alpha/\beta$-Testsignals in Form von Testsignalspannungen ($U_{1\alpha}$, $U_{1\beta}$), wobei die Testsignaleinspeisung in den Asynchronmotor (09) derart während einer Einnahme einer Stillstandslage des Rotors (11) erfolgt, dass der Rotor (11) drehmomentfrei bleibt, eine $U/V/W$-Transformationseinheit (43) zur Transformation des $\alpha/\beta$-Testsignals in ein dem Motor (9) zugeführtes $U/V/W$-Steuertestsignal, eine $\alpha/\beta$-Transformationseinheit (41) zur Transformation gemessener $U/V/W$-Meßsignalströme in $\alpha/\beta$-Meßsignalströme ($I_{1\alpha}$, $I_{1\beta}$) und eine Parameteridentifikationseinheit (67) zur Identifikation von Ersatzschaltbildparametern (03, 05, 15) auf Basis der Testsignalspannungen ($U_{1\alpha}$, $U_{1\beta}$) und der digital erfassten zeitlichen Abtastwerte der Meßsignalströme ($I_{1\alpha}$, $I_{1\beta}$) durch Analyse des Frequenzgangs der gemessenen Übertragungsfunktion unter Kenntnis der Übertragungsfunktion im Frequenzbereich eines Ersatzschaltbildes eines Asynchronmotors mittels Parameterextraktion umfasst.

8. Einrichtung nach Anspruch 7,
**dadurch gekennzeichnet,**
**dass** die Parameteridentifikationseinheit (67) ein Fouriertransformationsmittel (45), insbesondere ein FFT/DFT-Mittel, zur Fouriertransformation diskontinuierlicher $\alpha/\beta$-Signalwerte nach einem Welch-Verfahren, und ein Parameterbestimmungsmittel (47), insbesondere ein Levenberg-Marquardt-Übertragungsfunktions-Parameterbestimmungsmittel, umfasst.

**9.** Einrichtung nach einem der Ansprüche 7 oder 8,
**dadurch gekennzeichnet,**
**dass** des Weiteren eine Überwachungs- und Optimierungseinheit (49) umfasst ist, die eingerichtet ist, auf Basis der identifizierten Ersatzschaltbildparameter (03, 05, 15) Steuerparameter einer Wechselrichter-Steuereinrichtung (37) zu bestimmen, zu optimieren und/oder zu überwachen.

**10.** Motorsteuerungsvorrichtung (35) zur Steuerung eines Drehstrom-Asynchronmotors (09)
**gekennzeichnet dadurch,**
**dass** eine Identifikationseinrichtung (39) zur drehgeberlosen Identifikation elektrischer Ersatzschaltbildparameter (03, 05, 15) eines Drehstrom-Asynchronmotors (09) nach einem der vorgenannten Ansprüche 7 bis 9 umfasst ist, wobei die identifizierten Ersatzschaltbildparameter (03, 05, 15) zur Bestimmung, Optimierung und Überwachung des Motors (09) und/oder der Motorsteuerung verwendbar sind.

**11.** Vorrichtung nach Anspruch 10,
**dadurch gekennzeichnet,**
**dass** die Vorrichtung dergestalt eingerichtet ist, dass zumindest bei der erstmaligen Inbetriebnahme, bevorzugt mehrmals im Laufe des Betriebslebens, eine automatisierte Identifikation der Ersatzschaltbildparameter (03, 05, 15) während eines Rotorstillstands vornehmbar ist, wobei bei einer voreinstellbaren Abweichung der identifizierten Ersatzschaltbildparameter (03, 05, 15) von vorher bestimmten, gespeicherten und/oder modellbezogenen Ersatzschaltbildparametern (03, 05, 15) eine Fehlersignalisierung auslösbar ist.

**12.** Verwendung eines Verfahrens nach einem der vorangegangenen Verfahrensansprüche zur Bestimmung, Optimierung und Überwachung von Motorreglerparametern für die Steuerung elektrischer Antriebe, insbesondere zur Einstellung von Regelungsparametern einer Motorsteuerungsvorrichtung (35).

**Claims**

**1.** A method for the identification of electrical equivalent circuit parameters (03, 05, 15) of a three-phase asynchronous motor (09) without a shaft encoder, wherein the method comprises at least the step:

- assumption of a standstill position of the rotor (11), **characterized in that** comprising at least the steps:
- identical test signal infeed ($U_{1\alpha}$, $U_{1\beta}$) in $\alpha$ and $\beta$ stator axis direction as coordinate direction of a complex, two-coordinate system of the three-phase system of the asynchronous motor (09);
- measuring of the measuring signal current ($I_{1\alpha}$, $I_{1\beta}$) of the $\alpha$ and $\beta$ axial direction of the asynchronous motor (09);
- identification of equivalent circuit parameters (03, 05, 15) of the asynchronous motor (09) on the basis of the test signal voltages ($U_{1\alpha}$, $U_{1\beta}$) and the digital sample of the detected timing measuring signal currents ($I_{1\alpha}$, $I_{1\beta}$) through analysis of the frequency response of the measured transfer function with knowledge of the transfer function in the frequency range of an equivalent circuit of an asynchronous motor by means of parameter extraction;
wherein the test signal feed into the asynchronous motor (09) takes place such that the rotor (11) remains torque-free.

**2.** The method according to Claim 1,
**characterized in that**
at least one, in particular all
frequency functions
$G_1=I_{1\alpha}/U_{1\alpha}$, $G_2=I_{1\beta}/U_{1\alpha}$, $G_3=I_{1\alpha}/U_{1\beta}$, $G_4=I_{1\beta}/U_{1\beta}$ are determined for the identification of equivalent circuit parameters (03, 05, 15), wherein predeterminable deviations of the frequency response functions of bring about a repetition of the method or an error signal.

**3.** The method according to one of the previous claims,
**characterized in that**
the test signal is a pseudo-noise binary signal.

**4.** The method according to one of the previous claims,
**characterized in that**
the identification of the equivalent circuit parameters (03, 05, 15) comprises a Fourier transformation of time-discrete signals according to a Welch method.

5. The method according to one of the previous claims,
**characterized in that**
the identification of the equivalent circuit parameters (03, 05, 15) comprises a transmission function - parameter determination, in particular according to a Levenberg-Marquardt algorithm.

6. The method according to one of the previous claims,
**characterized in that**
the identified equivalent circuit parameters (03, 05, 15) are used in an adjustment and/or optimization of inverter control parameters and/or for motor monitoring.

7. An identification apparatus (39) for the identification of electrical equivalent circuit parameters (03, 05, 15) of a three-phase asynchronous motor (09) without a shaft encoder, that is controlled by a motor control device (35) including an inverter control apparatus (37),
**characterized in that**
the identification apparatus (39) furthermore comprises an inverter control interface unit (53) that can be connected to an inverter control apparatus (37) for the controlling communication and for the determining of the rotor standstill, a test signal generator apparatus (51) for generating and for the identical supplying in $\alpha$- and $\beta$- axis direction of the stator as a coordinate direction of a complex two coordinate system of the three-phase system of the asynchronous motor (9) of a $\alpha/\beta$- test signal in the form of test signal voltages ($U_{1\alpha}/U_{1\beta}$), wherein the test signal supplying to the asynchronous motor (9) takes place such that during a taking of a standstill position of the rotor (11), the rotor (11) remains torque-free, a U/V/W- transformation unit (43) for the transformation of the $\alpha/\beta$- test signal into a U/V/W control test signal, which is supplied to the motor (09), an $\alpha/\beta$ transformation unit (41) for the transformation of measured U/V/W measured signal currents into $\alpha/\beta$ measured signal currents ($I_{1\alpha}$, $I_{1\beta}$) and a parameter identification unit (67) for the identification of equivalent circuit parameters (03, 05, 15) based on the test signal voltages ($U_{1\alpha}/U_{1\beta}$) and the digitally recorded time samples of the measured signal currents ($I_{1\alpha}$, $I_{1\beta}$) by analyzing the frequency response of the measured transfer function with knowledge of the transfer function in the frequency range of an equivalent circuit of an asynchronous motor by means of parameter extraction.

8. The apparatus according to Claim 7,
**characterized in that**
the parameter identification unit (67) comprises a Fourier transformation means (45), in particular an FFT/DFT means for the Fourier transformation of discontinuous $\alpha/\beta$- scanning signal values according to a Welch method and comprises a parameter determination means (47), in particular a Levenberg-Marquardt transmission function-parameter determination means.

9. The apparatus according to one of Claims 7 or 8,
**characterized in that**
furthermore, a monitoring and optimization unit is comprised that is set up to determine, optimize and/or monitor control parameters of an inverter control apparatus (37) on the basis of the identified equivalent circuit parameters (03, 05, 15).

10. A motor control device (35) for controlling a three-phase asynchronous motor (09),
**characterized in that**
an identification apparatus (39) for the shaft-encoderless identification of electrical equivalent circuit parameters (03, 05, 15) of a three-phase asynchronous motor (09) according to one of the previous Claims 7 to 9 is comprised, wherein the identified equivalent circuit parameters (03, 05, 15) can be used for the determination, optimization and monitoring of the motor (09) and/or of the motor control.

11. The apparatus according to Claim 10,
**characterized in that**
the apparatus is arranged in such a manner that an automated identification of the equivalent circuit parameters (03, 05, 15) during about a rotor standstill can be carried out at least during the first startup, preferably several times in the course of the service life, wherein an error signal can be initiated upon a demonstrable deviation of the identified equivalent circuit parameters (03, 05, 15) from previously determined, stored and/or model-related equivalent circuit parameters (03, 05, 15).

**12.** The use of a method according to one of the previous method claims for the determination, optimization and monitoring of motor regulator parameters for the control of electrical drives, in particular for the adjusting of regulating parameters of a motor control device (35).

**Revendications**

**1.** Procédé d'identification sans résolveur de paramètres d'un schéma de branchement électrique de remplacement (03, 05, 15) d'un moteur asynchrone triphasé (09), qui comprend au moins l'étape suivante :

- adoption d'une position de repos du rotor (11),
**caractérisé en ce qu'**il comprend au moins les étapes suivantes :
- injection identique d'une tension signal de test ($U_{1\alpha}$, $U_{1\beta}$) dans les directions d'axes de stator $\alpha$ et $\beta$ constituant des directions de coordonnées d'un système complexe à deux coordonnées du système triphasé du moteur asynchrone (09) ;
- mesure des courants signal de mesure ($I_{1\alpha}$, $I_{1\beta}$) des directions d'axes $\alpha$ et $\beta$ du moteur asynchrone (09) ;
- identification de paramètres de schémas de branchement de remplacement (03, 05, 15) du moteur asynchrone (09) sur la base des tensions signal de test ($U_{1\alpha}$, $U_{1\beta}$) et des valeurs échantillons prises dans le temps, saisies en numérique, des courants signal de mesure ($I_{1\alpha}$, $I_{1\beta}$), par analyse de la réponse en fréquence de la fonction de transfert mesurée, la fonction de transfert étant connue dans le domaine de fréquence d'un schéma de branchement de remplacement d'un moteur asynchrone, exécutée par extraction de paramètres ;
l'injection du signal de test dans le moteur asynchrone (09) s'effectuant de telle sorte que le rotor (11) reste libre de tout couple.

**2.** Procédé selon la revendication 1, **caractérisé en ce qu'**au moins une fonction de réponse en fréquence G, de préférence toutes les fonctions de réponse en fréquence $G_1= I_{1\alpha}/U_{1\alpha}$, $G_2= I_{1\beta}/U_{1\alpha}$, $G_3= I_{1\alpha}/U_{1\beta}$, $G_4= I_{1\beta}/U_{1\beta}$, est ou sont obtenue(s) pour l'identification de paramètres de schémas de branchement de remplacement (03, 05, 15), des écarts des fonctions de réponse en fréquence pouvant être prédéterminés provoquant une répétition du procédé ou un signalement d'erreur.

**3.** Procédé selon l'une des revendications précédentes, **caractérisé en ce que** le signal de test est un signal binaire de pseudo bruit.

**4.** Procédé selon l'une des revendications précédentes, **caractérisé en ce que** l'identification des paramètres des schémas de branchement de remplacement (03, 05, 15) comprend une transformation de Fourier de signaux temporels discrets selon un procédé de Welsh.

**5.** Procédé selon l'une des revendications précédentes, **caractérisé en ce que** l'identification des paramètres des schémas de branchement de remplacement (03, 05, 15) comprend la détermination de paramètres par fonction de transfert, en particulier selon un algorithme de Levenberg-Marquardt.

**6.** Procédé selon l'une des revendications précédentes, **caractérisé en ce que** les paramètres des schémas de branchement de remplacement identifiés (03, 05, 15) sont utilisés lors d'un ajustement et/ou d'une optimisation de paramètres de commande d'un onduleur et/ou pour le contrôle du moteur.

**7.** Dispositif d'identification (39) pour l'identification sans résolveur de paramètres de schémas de branchement électrique de remplacement (03, 05, 15) d'un moteur asynchrone triphasé (09) qui est commandé par une commande (35) comprenant un dispositif de commande d'onduleur (37), **caractérisé en ce que** le dispositif d'identification (39) comprend en outre une unité interface d'onduleur (53) qui peut être connectée au dispositif de commande (37) de l'onduleur pour la communication des commandes et pour la détermination de l'état de repos du rotor, un dispositif de production de signaux de test (51) pour la production et l'injection identique dans les directions d'axes du stator $\alpha$ et $\beta$, constituant des directions de coordonnées d'un système complexe à deux coordonnées du système triphasé du moteur asynchrone (09), d'un signal de test $\alpha/\beta$ sous la forme de tensions signal de test ($U_{1\alpha}$, $U_{1\beta}$), l'injection d'un signal de test dans le moteur asynchrone (09) s'effectuant de telle sorte que, lorsqu'est adopté un état de repos du rotor (11), le rotor (11) reste libre de tout couple, une unité de transformation $U/V/W$ (43) pour la transformation du signal de test $\alpha/\beta$ en un signal de test de commande $U/V/W$ envoyé au moteur (9), une unité de transformation $\alpha/\beta$ (41) pour la transformation de courants signal de mesure $U/V/W$ mesurés en courants signal de mesure $\alpha/\beta$ ($I_{1\alpha}$, $I_{1\beta}$) et une unité d'identification de paramètres (67) destinée à l'identification de paramètres de schémas de branchement de remplacement (03, 05, 15) sur la base des tensions signal de test ($U_{1\alpha}$, $U_{1\beta}$) et des valeurs échantillons prises dans le temps, saisies en numérique, des courants signal de mesure ($I_{1\alpha}$, $I_{1\beta}$), par analyse de la réponse en fréquence de la fonction de transfert mesurée, la fonction de transfert étant connue dans le domaine de fréquence d'un schéma de branchement de remplacement d'un moteur asynchrone, exécutée par extraction de paramètres.

8. Dispositif selon la revendication 7, **caractérisé en ce que** l'unité d'identification de paramètres (67) comprend un moyen de transformation de Fourier (45), en particulier un moyen FFT/DFT servant à effectuer la transformation de Fourier de valeurs discontinues du signal $\alpha/\beta$ selon un procédé de Welch, et un moyen de détermination de paramètres (47), en particulier un moyen de détermination de paramètres d'une fonction de transfert selon Levenberg-Marquart.

9. Dispositif selon l'une des revendications 7 ou 8, **caractérisé en ce qu'**il comprend en outre une unité de contrôle et d'optimisation (49) qui est conçue pour déterminer, optimiser et/ou contrôler des paramètres de commande d'un dispositif de commande d'onduleur (37) sur la base des paramètres des schémas de branchement de remplacement identifiés (03, 05, 15).

10. Dispositif de commande de moteur (35) pour la commande d'un moteur asynchrone triphasé (09), **caractérisé en ce qu'**il comprend un dispositif d'identification (39) pour l'identification sans résolveur de paramètres de schémas électriques de branchement de remplacement (03, 05, 15) d'un moteur asynchrone triphasé (09) selon l'une des revendications précédentes 7 à 9, les paramètres des schémas de branchement de remplacement identifiés (03, 05, 15) pouvant être utilisés pour la détermination, l'optimisation et le contrôle du moteur (09) et/ou de la commande du moteur.

11. Dispositif selon la revendication 10, **caractérisé en ce que** le dispositif est conçu de telle sorte qu'au moins lors de la première mise en service, de préférence plusieurs fois au cours de la durée de vie utile, une identification automatisée des paramètres des schémas de branchement de remplacement (03, 05, 15) peut être exécutée pendant un état de repos du rotor, et **en ce que**, dans le cas d'un écart prédéterminable des paramètres des schémas de branchement de remplacement identifiés (03, 05, 15), par rapport à des paramètres de schémas de branchement de remplacement prédéterminés, mémorisés et/ou rapportés à un modèle (03, 05, 15), un signalement d'erreur peut être déclenché.

12. Utilisation d'un procédé selon l'une des revendications précédentes pour la détermination, l'optimisation et le contrôle de paramètres de régulateurs de moteurs servant à commander des entraînements électriques, en particulier pour l'ajustement de paramètres de régulation d'un dispositif de commande de moteur (35).

Fig. 1

Fig. 2

Fig. 3

Fig. 4

Stand der Technik

Fig. 5

Fig. 6

Fig. 7

Begin

S1: Rotor-Stopposition ($n$=0)

S2: PRBS-Stimulation
in $\alpha/\beta$-System

S3: $\alpha/\beta$ in *U*/*V*/*W*-Conversion
& Motor Stimulation

S4: Monitoring $u(n),i(n)$

S5: Fourier Transformation
$u(\text{n}),i(\text{n})->u(\text{k}),i(\text{k})$

S6: Parameter Extraction &
System Identification
$G(\text{k})=i(\text{k})/u(\text{k}) -> L_{1\sigma}, L'_{2\sigma}, L_h, R_1, R'_2$

S7: Motorcontrol-Optimization

End

Fig. 8

Fig. 9

$$M_{mi} = 3/2\, p\, (\Psi_{1\alpha}\, I_{1\beta}\, -\, \Psi_{1\beta}\, I_{1\alpha})$$

Fig. 10

alle Einzel-Frequenzgänge

Fig. 11

EP 2 421 145 B1

Fig. 12

Fig. 13

$$M_{mi} = 3/2\, p\, (\Psi_{1\alpha}\, I_{1\beta} - \Psi_{1\beta}\, I_{1\alpha})$$

Fig. 14

Fig. 15

30

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2001103798 A
- DE 4411149 A1

- EP 0704709 A2


**In der Beschreibung aufgeführte Nicht-Patentliteratur**

- **VON SEBASTIAN VILLWOCK.** *Identifikationsmethoden für die automatisierte Inbetriebnahme und Zustandsübomachung elektrischer Antriebe,* 2007
- **S. VILLWOCK ; J. M. PACAS.** Applikation of the Welch-Method for the Identification of Two and Three Mass Systems. *IEEE Transactions on Industrial Electronics,* Januar 2008, vol. 55 (1), 457-466

- **P. SZCZUPAK ; J. M. PACAS.** Automatic identification of a PMSM Drive Equipped with an Output LC-Filter. *IEEE Industrial Electronics, IECON 2006, 32nd Annual Confrence,* November 2006, 1143-1148